# EUROPÄISCHE PATENTSCHRIFT

(11) **EP 2 643 194 B1**
(45) Veröffentlichungstag und Bekanntmachung des Hinweises auf die Patenterteilung: **12.08.2015**
(21) Anmeldenummer: 11785678.1
(22) Anmeldetag: 22.11.2011
(51) Int. Cl.: B60T 7/04

(54) **VERFAHREN ZUR FEHLERERKENNUNG EINES BEDIENSCHALTERS ZUR AUSLÖSUNG EINER FAHRZEUGFUNKTION EINES FAHRZEUGES SOWIE BEDIENSCHALTER ZUR DURCHFÜHRUNG DES VERFAHRENS**
METHOD FOR DETECTING A FAULT OF AN OPERATING SWITCH FOR INITIATING A VEHICLE FUNCTION OF A VEHICLE AND OPERATING SWITCH FOR CARRYING OUT THE METHOD
PROCÉDÉ PERMETTANT D'IDENTIFIER UNE DÉFAILLANCE D'UN INTERRUPTEUR DE COMMANDE SERVANT À DÉCLENCHER UNE FONCTION D'UN VÉHICULE ET INTERRUPTEUR DE COMMANDE PERMETTANT LA MISE EN OEUVRE DUDIT PROCÉDÉ

(30) Priorität: 23.11.2010 DE 102010061809; 21.11.2011 DE 102011086756
(43) Veröffentlichungstag der Anmeldung: 02.10.2013
(73) Patentinhaber: Continental Teves AG & Co. oHG, 60488 Frankfurt (DE)
(72) Erfinder: HEISE, Andreas, 64390 Erzhausen (DE); HARTMANN, Ralf, 65830 Kriftel (DE)
(86) Internationale Anmeldenummer: PCT/EP2011/070658
(87) Internationale Veröffentlichungsnummer: WO 2012/069461

(56) Entgegenhaltungen:
- WO-A1-00/29268
- WO-A1-2007/014952
- WO-A1-2007/071299
- WO-A2-02/095282
- DE-A1- 19 962 556
- DE-A1-102006 009 729
- DE-C1- 19 944 461

## Beschreibung

Die Erfindung betrifft ein Verfahren zur Fehlererkennung eines mittels wenigstens einer Signalleitung an eine Auswerteeinheit angeschlossenen Bedienschalters mit wenigstens einer ersten Schaltebene zur Auslösung einer Fahrzeugfunktion eines Fahrzeuges gemäß Oberbegriff des Patentanspruchs 1 sowie einen Bedienschalter zur Durchführung des erfindungsgemäßen Verfahrens gemäß Oberbegriff des Patentanspruchs 18.

Moderne Fahrzeuge weisen vielfach elektronische Parkbremssysteme auf, insbesondere solche, bei denen auf Anforderung durch den Fahrer elektrische Aktuatoren eine Zuspannvorrichtung an den Reibbremsen der Hinterachse betätigen. Auf Grund der hohen Sicherheitsrelevanz müssen solche elektrisch betätigbaren Feststellbremsen verschiedenen rechtlichen bzw. gesetzlichen Vorgaben entsprechen.

Für einen als Bedienschalter ausgebildeten Parkbremsbedienschalter sowie dessen Verbindung zu einer Auswerteeinheit als Steuergerät, welches die Parkbremse ansteuert, ist es daher erforderlich, dass Einzelfehler wie Kurzschlüsse der einzelnen Leitungen zueinander oder gegen eine der Versorgungsspannungen, Unterbrechungen einer Leitung und Defekte der Schaltkontakte unabhängig von der Parkbremsbetätigung zeitnah sicher erkannt werden müssen. Auch Fehlertoleranz gegenüber einem Einzelfehler ist in einigen Fällen erforderlich, da eine Betätigung der Parkbremse nach Anforderung durch den Fahrer auch bei Auftreten eines Einzelfehlers erfolgen muss.

Die EP 1 128 999 B2 offenbart eine Vorrichtung sowie ein Verfahren zur Steuerung einer elektrisch betätigbaren Feststellbremse, wobei eine Eingabevorrichtung ein elektrisches Schaltmittel mit mehreren Schaltstellungen aufweist, das mit redundant ausgeführten Schaltern gekoppelt ist, welche in parallel arbeitenden Schaltebenen mit eigener Energieversorgung und Masseverbindung angeordnet sind. Die Eingabevorrichtung emittiert in jeder Schaltstellung zumindest zwei redundante Ausgangssignale, wobei jeder Schaltebene zusätzlich jeweils mindestens zwei Signalleitungen zugeordnet sind. Nachteilhafterweise sind für die Verbindung zwischen Eingabevorrichtung und Steuergerät mindestens acht Leitungen erforderlich.

In der DE102008015910 ist ein Verfahren zur Überprüfung der Funktionsfähigkeit einer Schalteinheit offenbart, welche mehrere Schalter sowie zumindest eine vorzugsweise interne Steuereinheit aufweist und über zumindest eine Schnittstelleneinheit mit einem externen Steuergerät verbindbar ist. Die Funktionsfähigkeit der Schalteinheit wird hierbei durch eine in dem Steuergerät ausgeführten internen Diagnoseroutine oder einer in dem externen Steuergerät ausgeführten externen Diagnoseroutine überprüft, indem durch die Diagnoseroutinen zumindest ein Testsignal erzeugt wird, welches an zumindest einen der Schalter angelegt wird, und in der Steuereinheit die von den Schaltern empfangenen Eingangssignale ausgewertet werden. In der bevorzugten Ausführungsform ist die Schalteinheit wegen der internen Steuereinheit aufwendig, bei Verwendung einer externen Steuereinheit wären mindestens fünf Leitungen erforderlich.

Die WO 2009/068264 offenbart eine Vorrichtung zum elektrischen Betätigen eines sicherheitskritischen Systems, mit wenigstens zwei Anschlüssen, wenigstens einem Schalter und einem Bedienelement, mittels dem wenigstens zwei Betriebszustände für das System wählbar sind, durch die Schaltstellungen des wenigstens einen Schalters bestimmt werden. Durch die Verwendung wenigstens eines Stromrichtungselements wird erreicht, dass ein unidirektionaler Stromfluss zwischen den wenigstens zwei Anschlüssen erfolgt, der für einen ersten Betriebszustand in Richtung vom ersten zum zweiten Anschluss erfolgt und für einen weiteren Betriebszustand in umgekehrter Richtung vom zweiten zum ersten Anschluss erfolgt. Um eine Toleranz gegenüber einem Einzelfehler bereitzustellen, sind daher mindestens vier Anschlüsse bzw. vier Leitungen zwischen Schalteinheit und Steuergerät erforderlich.

Aus der WO 2007/071299 A1 ist ein überprüfbarer Taster mit zwei parallelen, identischen und mechanisch gekoppelten Schaltgruppen zum Betätigen einer elektro-pneumatischen Handbremse bekannt, welcher über vier Anschlussleitungen an ein elektronisches Steuergerät (ECU) angeschlossen ist. Zur Überprüfung werden die Potentiale der Anschlussleitungen bzw. des Tasters ausgewertet.

Neben den für die Anforderung der Parkbremsbetätigung erforderlichen Leitungen werden häufig eine oder zwei weitere Leitungen zum Parkbremsbedienschalter verlegt, die eine Ansteuerung einer Signalleuchte im oder am Schalter ermöglichen. Hierdurch kann der Betriebszustand der Parkbremse (angezogen oder gelöst) angezeigt werden und/oder eine Beleuchtung des Schalters erfolgen.

Ein Bedienschalter für eine Parkbremse mit den Schalterstellungen Anziehen/Neutral/Lösen und einer Beleuchtung benötigt nach dem Stand der Technik demnach mindestens fünf Leitungen zwischen Parkbremssteuergerät und Parkbremsbedienschalter. Aufgabe der vorliegenden Erfindung ist es daher, ein Verfahren zur Fehlererkennung eines Bedienschalters der eingangs genannten Art anzugeben, mit welchem ein Einzelfehler sicher zeitnah erkannt wird, vorzugsweise ohne dass die Erkennung des Schaltzustandes durch einen solchen Fehler negativ beeinflusst wird, und mit einem solchen erfindungsgemäßen Verfahren die Realisierung eines Bedienschalters mit einer möglichst geringen Anzahl von Verbindungsleitungen zwischen Bedienschalter und Steuereinrichtung ermöglicht wird. Ferner ist es Aufgabe der Erfindung, einen Bedienschalter zur Durchführung des erfindungsgemäßen Verfahrens bereitzustellen.

Die erstgenannte Aufgabe wird gelöst durch Verfahren mit den Merkmalen des Patentanspruchs 1.

Ein solches Verfahren zur Fehlererkennung eines mittels wenigstens einer Signalleitung an eine Auswerteeinheit angeschlossenen Bedienschalters mit wenigstens einer ersten Schaltebene zur Auslösung einer Fahrzeugfunktion eines Fahrzeuges, bei dem ein die Schaltstellung spezifizierendes Signal zur Auslösung der Fahrzeugfunktion von der Auswerteeinheit erfasst und ausgewertet wird, zeichnet sich erfindungsgemäß dadurch aus, dass
- die erste Schaltebene einenends an ein erstes Potential der Bordnetzspannung des Fahrzeugs angeschlossen wird und andernends zur Bildung eines ersten Kontaktzweiges in einer ersten Schaltstellung mit der Signalleitung verbindbar ist,
- die erste Schaltebene von einer Diodeneinrichtung hinsichtlich des ersten Potentials der Bordnetzspannung in Sperrrichtung überbrückt wird,
- mittels der Auswerteeinheit eine Prüfspannung erzeugt wird, deren Spannungswert betragsmäßig größer als das erste Potential ist,
- die Signalleitung des ersten Kontaktzweiges mit der Prüfspannung beaufschlagt wird, und
- das auf der Signalleitung des ersten Kontaktzweiges sich einstellende Potential zur Fehlererkennung durch die Auswerteeinheit ausgewertet wird.

Dieses erfindungsgemäße Verfahren ermöglicht eine Fehlerkennung, die den Anschluss des Bedienschalters an ein Bordnetz eines Fahrzeugs betrifft und mittels einer Prüfspannung durchgeführt wird, die bspw. bei Anschluss einer Schaltebene des Bedienschalters an das positive Potential als erstes Potential einer Bordnetzspannung größer ist als das positive Potential oder bei Anschluss der Schaltebene des Bedienschalters an das Bezugspotential als zweites Potential der Bordnetzspannung negativ ist. So lässt sich bei einer Beaufschlagung der mit der Schaltebene verbundenen Signalleitung mit dieser Prüfspannung mittels der in Sperrrichtung geschalteten Diodeneinrichtung ein Abriss des Bedienschalters von der Spannungsversorgung, sowohl im unbetätigten als auch im betätigten Zustand des Bedienschalters detektieren.

Dieses erfindungsgemäße Verfahren lässt die Verwendung von Schließerkontakten zu, wodurch sich eine hohe Designfreiheit zur Realisierung des Bedienschalters ergibt.

Wenn das System aus Bedienschalter mit Signalleitung und Auswerteeinheit sich in einem Stand-by-Modus befindet, ist die Signalleitung spannungsfrei ausführbar, selbst wenn die Auswerteeinheit wakeup-fähig ist.

In einer Ausgestaltung der Erfindung ist es vorgesehen, dass der Bedienschalter in der ersten Schaltstellung mit einer zweiten parallelen Schaltebene ausgebildet ist, die zweite Schaltebene von einer Diodeneinrichtung hinsichtlich des ersten Potentials der Bordnetzspannung in Sperrrichtung überbrückt wird, und zur Bildung eines zweiten Kontaktzweiges die zweite Schaltebene über eine weitere Signalleitung mit der Auswerteeinheit verbindbar ist.

Ein solcher Bedienschalter, bspw. als Taster ausgeführt, ist mit den beiden Schaltebenen einfach redundant ausgeführt und liefert mit den zugehörigen zwei Signalleitungen einfach redundante Schaltsignale zur eindeutigen Erkennung der Schaltstellung. Da beide Schaltebenen jeweils mit einer Diodeneinrichtung überbrückt werden, kann ein Abriss des Bedienschalters vom ersten Potential der Bordnetzspannung, also bspw. von dem positiven Potential der Bordnetzspannung jeweils über beide Signalleitungen detektiert werden, indem weiterbildungsgemäß der zweite Kontaktzweig an das erste Potential der Bordnetzspannung des Fahrzeugs angeschlossen wird, die Signalleitung des zweiten Kontaktzweiges mit der Prüfspannung beaufschlagt wird, und das auf der Signalleitung des zweiten Kontaktzweiges sich einstellende Potential zur Fehlererkennung durch die Auswerteeinheit ausgewertet wird.

Diese einfache Redundanz hinsichtlich der Schaltebene eines Bedienschalters kann gemäß einer vorteilhaften Weiterbildung der Erfindung noch erhöht werden, indem der Bedienschalter in der ersten Schaltstellung mit einer dritten parallelen Schaltebene ausgebildet wird, die dritte Schaltebene von einer Diodeneinrichtung hinsichtlich des ersten Potentials der Bordnetzspannung in Sperrrichtung überbrückt wird, und zur Bildung eines dritten Kontaktzweiges die dritte Schaltebene über eine weitere Signalleitung mit der Auswerteeinheit verbindbar ist. Auch mit diesem dritten Kontaktzweig lässt sich ein Abriss des Bedienschalters von der Versorgungsspannung detektieren, indem auch die Signalleitung des dritten Kontaktzweiges mit der Prüfspannung beaufschlagt wird, und das auf der Signalleitung des dritten Kontaktzweiges sich einstellende Potential zur Fehlererkennung durch die Auswerteeinheit ausgewertet wird.

Weiterhin ist es nach einer Ausgestaltung der Erfindung vorgesehen, die in einer Schaltstellung redundanten Kontaktebenen nicht an das gleiche Potential der Bordnetzspannung, sondern jeweils an verschiedene Potential der Bordnetzspannung angeschlossen werden, d .h. dass der zweite Kontaktzweig an ein zweites Potential der Bordnetzspannung des Fahrzeugs angeschlossen wird. Entsprechend ist es auch möglich mit drei parallelen Schaltebenen die dritte Schaltebene, also den dritten Kontaktzweig an das zweite Potential der Bordnetzspannung anzuschließen.

Besonders vorteilhaft ist das erfindungsgemäße Verfahren für einen Bedienschalter mit einer zweiten Schaltstellung, die zwei parallele Schaltebenen aufweist, anzuwenden, so dass die erste und zweite Schaltebene einerseits mit einem zweiten Potential der Bordnetzspannung verbunden wird und andererseits die erste Schaltebene mit dem ersten Kontaktzweig und die zweite Schaltebene mit dem zweiten Kontaktzweig verbunden wird. Damit kann mittels der Auswerteeinheit über die beiden Signalleitungen auch die zweite Schaltstellung detektiert und entsprechende Testprozeduren durchgeführt werden.

Ferner ist es weiterbildungsgemäß vorgesehen auch einen Bedienschalter mit drei parallelen Kontaktebenen in einer ersten Schaltstellung auch drei Schaltebenen in einer zweiten Schaltstellung vorzusehen und mit dem zweiten Potential der Bordnetzspannung bzw. mit den jeweiligen Kontaktzweigen der Schaltebenen der ersten Schaltstellung zu verbinden.

Das erfindungsgemäße Verfahren ist weiterbildungsgemäß auch für solche Bedienschalter einsetzbar, deren redundanten Schaltebenen in einer ersten Schaltstellung an unterschiedliche Potentiale der Bordnetzspannung angeschlossen sind und in einer zweiten Schaltstellung ebenso entsprechend redundante Schaltebenen aufweist. Hierzu wird die erste Schaltebene einenends mit dem ersten Potential der Bordnetzspannung und andernends mit dem zweiten Kontaktzweig verbunden, während die zweite Schaltebene einenends mit dem zweiten Potential der Bordnetzspannung und andernends mit dem ersten Kontaktzweig verbunden wird.

Entsprechendes wird vorteilhaft auch mit einem Bedienschalter mit drei parallelen Kontaktebenen in einer ersten Schaltstellung erfindungsgemäß ausgeführt, die nicht alle mit dem gleichen Potential der Bordnetzspannung verbunden ist. Hiernach ist weiterbildungsgemäß vorgesehen, dass der Bedienschalter in eine zweite Schaltstellung mit einer ersten und hierzu parallelen zweiten und dritten Schaltebene betätigbar ist, die erste Schaltebene einenends mit einem ersten Potential der Bordnetzspannung, vorzugsweise mit einem ersten Potential einer weiteren Bordnetzspannung und andernends mit dem ersten Kontaktzweig verbunden wird und die zweite und dritte Schaltebene einenends mit dem zweiten Potential des Bordnetzes und andernends die zweite Schaltebene dem zweiten Kontaktzweig und die dritte Schaltebene mit dem dritten Kontaktzweig verbunden wird.

Wie bereits oben ausgeführt, ist das erfindungsgemäße Verfahren so ausgestaltet, dass als Prüfspannung ein höherer Wert als das positive Potential der Bordnetzspannung verwendet wird, wenn die mit der Diodeneinrichtung überbrückten Schaltebenen an dieses positive Potential der Bordnetzspannung angeschlossen sind oder umgekehrt, wenn solche Schaltebenen auf dem Bezugspotential der Bordnetzspannung liegen, als Prüfspannung eine gegenüber dem Bezugspotential negative Spannung erzeugt wird.

In einer weiteren Ausgestaltung der Erfindung wird der Bedienschalter mit wenigstens einer Leuchtdiode ausgebildet, die über eine LED-Leitung mit der Auswerteeinheit verbunden wird. Damit kann diese Leuchtdiode zur Anzeige des Zustands der mit dem Bedienschalter betätigbaren Fahrzeugfunktion mittels der Auswerteeinheit angesteuert werden.

Eine solche LED-Leitung kann in vorteilhafter Weise dazu genutzt werden, dem Bedienschalter das Bezugspotential des Bordnetzes zuzuführen, insbesondere auch dann, wenn ein Abriss des GND-Anschlusses an dem Bedienschalter von der Auswerteeinheit detektiert wurde.

Weiterhin bietet es sich gemäß einer Weiterbildung der Erfindung an, dass zur weiteren Fehlererkennung der erste und/oder zweite Kontaktzweig mittels der Auswerteeinheit mit der Bordnetzspannung oder dem Bezugspotential der Bordnetzspannung beaufschlagt wird und in Abhängigkeit der Schaltstellung des Bedienschalters das sich auf den Leitungen der Kontaktzweige einstellende Potentiale erfasst und ausgewertet werden. So können in allen Schaltstellungen durch Beschalten der Signalleitungen mit verschiedenen Spannungen und entsprechende Auswertung der auftretenden Potentiale Fehler wie Kurzschlüsse oder Leitungsabrisse erkannt werden.

Auch ist es vorteilhaft, die Schaltkontakte des Bedienelementes durch ein Strombegrenzungselement, vorzugsweise einen elektrischen Widerstand zu schützen, bspw. wenn fälschlich "hart" eine Spannung an die Schaltkontakte der Schaltebenen gelegt werden. Auch Dioden können zusätzlich hierzu verwendet werden.

Insgesamt wird mit diesem erfindungsgemäßen Verfahren ein System aus Bedienschalter, Signalleitungen und Auswerteeinheit zur Verfügung gestellt, welches gegen EMV-Einkopplungen und Potentialunterschiede im Bordnetz sehr unempfindlich ist.

Die zweitgenannte Aufgabe wird durch die kennzeichnenden Merkmale des Patentanspruchs 19 gelöst.

Ein solcher Bedienschalter mit wenigstens einem eine erste Schaltebene bildenden Schließerkontakt zur Auslösung einer Fahrzeugfunktion eines Fahrzeuges, welcher mittels wenigstens einer Signalleitung an eine Auswerteeinheit angeschlossen ist, zeichnet sich erfindungsgemäß dadurch aus, dass
- die erste Schaltebene einenends an ein erstes Potential der Bordnetzspannung des Fahrzeugs angeschlossen ist und andernends zur Bildung eines ersten Kontaktzweiges in einer ersten Schaltstellung mit der Signalleitung verbunden ist,
- eine Diodeneinrichtung vorgesehen ist, die die erste Schaltebene hinsichtlich des ersten Potentials der Bordnetzspannung in Sperrrichtung überbrückt,
- die Auswerteeinheit eine Prüfspannungserzeugungseinheit zur Erzeugung einer Prüfspannung aufweist, deren Spannungswert betragsmäßig größer als das erste Potential ist,
- die Auswerteinheit ausgebildet ist, die Signalleitung des ersten Kontaktzweiges mit dem Testpotential zu beaufschlagen und das auf der Signalleitung des ersten Kontaktzweiges sich einstellende Potential zur Fehlererkennung auszuwerten.

Ein solcher Bedienschalter mit lediglich Schließerkontakten weist einen einfachen und robusten, insbesondere hinsichtlich EMV-Störungen unempfindlichen Aufbau auf.

Vorteilhafte Ausgestaltungen des erfindungsgemäßen Bedienschalters ergeben sich aus den abhängigen Patentansprüchen 20 bis 31.

Das erfindungsgemäße Verfahren ist vorteilhaft für die Verwendung eines Bedienschalters in einem Kraftfahrzeug, insbesondere um ein elektronisches Parkbremssystem zu bedienen.

Die Erfindung wird nachfolgend anhand von Ausführungsbeispiels unter Bezugnahme auf die beigefügten Figuren ausführlich beschrieben. Es zeigen:

Es zeigen
- Figur 1: eine Schaltungsanordnung als Ausführungsbeispiel des erfindungsgemäßen Verfahrens mit einem Bedienschalter mit drei Schalterstellungen und einer LED-Anzeige,
- Figur 2: eine Schaltungsanordnung als weiteres Ausführungsbeispiel des erfindungsgemäßen Verfahrens mit einem Bedienschalter mit drei Schalterstellungen und einer LED-Anzeige,
- Figur 3: eine Schaltungsanordnung gemäß Figur 2 mit einer schematischen Schnittstellenschaltung eines Steuergerätes,
- Figuren 4: Tabellendarstellung für Testprozeduren und Fehlererkennung eines Bedienschalter gemäß Figur 3,
- Figur 5: eine Schaltungsanordnung als weiteres Ausführungsbeispiel des erfindungsgemäßen Verfahrens mit einem Bedienschalters mit Verzicht auf eine mechanische Verriegelung,
- Figur 6: eine Schaltungsanordnung als weiteres Ausführungsbeispiel des erfindungsgemäßen Verfahrens mit einem Bedienschalter als Taster mit einer LED-Anzeige,
- Figur 7: eine Schaltungsanordnung als weiteres Ausführungsbeispiel des erfindungsgemäßen Verfahrens mit einem Bedienschalter mit einer Schaltebene,
- Figur 8: eine Schaltungsanordnung als weiteres Ausführungsbeispiel des erfindungsgemäßen Verfahrens mit einem Bedienschalter gemäß Figur 7 mit zusätzlich einer Erkennung eines Kurzschlusses der Signalleitung gegen eine Versorgungsspannung,
- Figur 9: eine Schaltungsanordnung als weiteres Ausführungsbeispiel des erfindungsgemäßen Verfahrens, bei dem eine Fehlererkennung des Bedienschalters mit einer gegenüber der Bezugsspannung (GND) negativen Prüfspannung erfolgt,
- Figur 10: eine Schaltungsanordnung als weiteres Ausführungsbeispiel des erfindungsgemäßen Verfahrens mit einem Bedienschalter mit redundantem Bordnetzspannung,
- Figur 11: eine Schaltungsanordnung als weiteres Ausführungsbeispiel des erfindungsgemäßen Verfahrens mit einem Bedienschalter mit doppelter Masseversorgung,
- Figur 12: eine Schaltungsanordnung als weiteres Ausführungsbeispiel des erfindungsgemäßen Verfahrens mit einem Bedienschalter mit dreifach redundanten Schaltebenen in den Schaltstellungen,
- Figur 13: eine Schaltungsanordnung als weiteres Ausführungsbeispiel des erfindungsgemäßen Verfahrens mit einem Bedienschalter mit dreifach redundanten Schaltebenen in den Schaltstellungen, und
- Figur 14: eine Schaltungsanordnung als weiteres Ausführungsbeispiel des erfindungsgemäßen Verfahrens mit einem Bedienschalter ohne Masse-Anschluss.

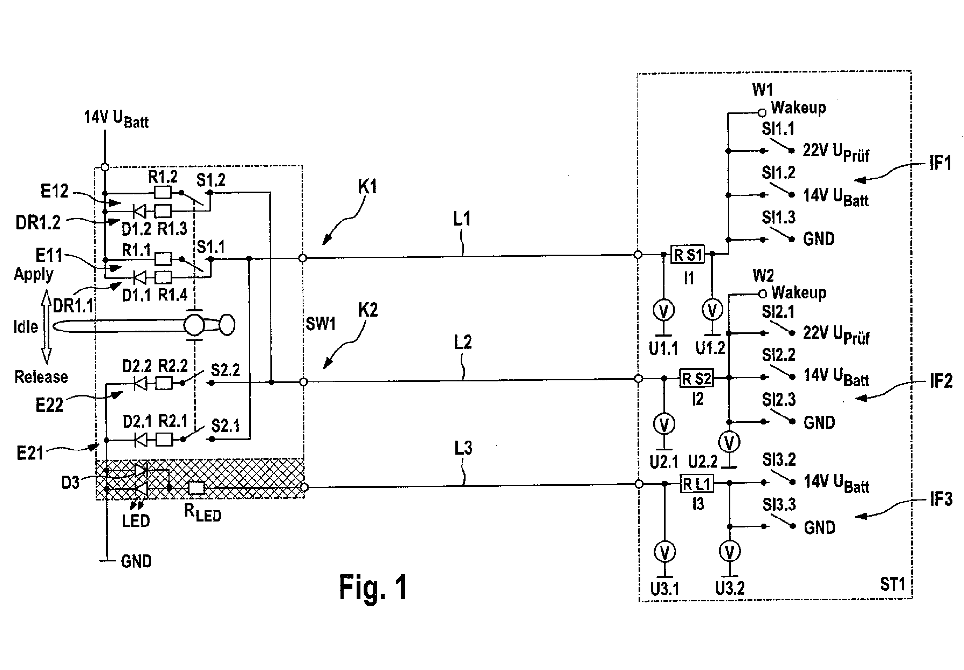

Figur 1 zeigt einen Parkbremsschalter als Bedienschalter SW1, der über zwei Signalleitungen L1 und L2 sowie einer LED-Leitung L3 mit einem Steuergerät, bspw. ein Parkbremssteuergerät als Auswerteeinheit ST1 verbunden ist. Die Anbindung dieser Leitungen L1 bis L3 an das Steuergerät ST1 erfolgt jeweils über eine Interfaceschaltung IF1, IF2 und IF3. Zur Erfassung eines Fahrerwunsches detektiert das Parkbremssteuergerät ST1 die Schaltstellung des Bedienschalters SW1 und löst dann die entsprechende Funktion, also entweder Spannen der Parkbremse oder Lösen der Parkbremse aus.

Der Bedienschalter SW1 gemäß Figur 1 weist drei Stellungen auf, eine Neutralstellung (Idle), einen ersten Schaltzustand (Apply, Anziehen), mit dem die Funktion "Anziehen der Parkbremse" ausgelöst wird und einen zweiten Schaltzustand (Release, Lösen), mit dem die Funktion "Lösen der Parkbremse" ausgelöst wird.

In jeder dieser Schaltstellungen weist der Bedienschalter SW1 einfach redundante Schaltebenen auf, also jeweils zwei Schaltebenen E11 und E12 bzw. E21 und E22 in der ersten bzw. zweiten Schaltstellung. Jeder dieser Schaltebenen besteht aus einem Schließer S1.1 und S1.2 bzw. S2.1 und S2.2 als Schaltkontakt, denen jeweils ein Schutzwiderstand R1.1 und R1.2 bzw. R2.1 und R2.2 in Reihe geschaltet ist. Ferner sind in Reihe zu den Widerständen R2.1 und R2.2 der beiden Schaltebenen E21 und E22 in der zweiten Schaltstellung jeweils eine Diode D2.1 und D2.2 in Durchlassrichtung geschaltet.

Wird der Bedienschalter SW1 in seine erste Schaltstellung "Apply" betätigt, werden die Schaltkontakte S1.1 und S1.2 geschlossen. Bei einer Betätigung des Bedienschalter SW1 in die zweite Schaltstellung "Release" werden die Schaltkontakte S2.1 und S2.2 geschlossen. Im unbetätigten Zustand verbleibt der Bedienschalter SW1 in seiner Neutralstellung (Idle).

Die beiden Schaltebenen E11 und E12 liegen in der ersten Schaltstellung einenends auf dem positiven Potential der Bordnetzspannung U_{Batt}, also bspw. auf 14V und andernends ist die Schaltebene E11 bzw. E12 zur Bildung eines ersten bzw. zweiten Kontaktzweiges K1 bzw. K2 mit der Signalleitung L1 bzw. L2 verbunden, die ihrerseits an eine Interfaceschaltung IF1 bzw. IF2 des Steuergerätes ST1 angeschlossen sind.

Ferner werden diese beiden Schaltebenen E11 und E12 jeweils von einer Diodeneinrichtung DR1.1 bzw. DR1.2 überbrückt, die aus in Serie geschalteten Diode D1.1 und Widerstand R1.4 bzw. Diode D1.2 und Widerstand R1.3 aufgebaut ist, wobei die beiden Dioden D1.1 und D1.2 jeweils bezgl. der Bordnetzspannung U_{Batt} in Sperrrichtung gepolt sind.

Die beiden Schaltebenen E21 und E22 der zweiten Schaltstellung des Bedienschalters SW1 sind einenends mit dem Bezugspotential der Bordnetzspannung, als der Masse GND verbunden und andernends auf den ersten bzw. zweiten Kontaktzweig K1 bzw. K2 geführt und sind dort mit der ersten bzw. zweiten Schaltebene E11 bzw. E22 verbunden.

Desweiteren weist der Bedienschalter SW1 eine Signalleuchte LED auf, die über die LED-Leitung L3 mit einer Interfaceschaltung IF3 des Steuergerätes ST1 verbunden ist und von diesem zur Anzeige des Zustandes der mit dem Bedienschalter betätigbaren Funktion (d. h. Parkbremse angezogen oder gelöst) angesteuert wird. Diese Leuchtdiode LED ist direkt mit der Masse GND der Bordnetzspannung verbunden und liegt über einen Schutzwiderstand R_{LED} an der LED-Leitung L3. Ferner ist eine Diode D3 antiparallel zur Leuchtdiode LED geschaltet, so dass bspw. bei einem GND-Abriss an dem Bedienschalter SW1 eine Masse-Versorgung über die LED-Leitung L3 durch das Steuergerät ST1 bereitgestellt werden kann. Die LED-Leitung L3 dient zur Überprüfung des Vorhandenseins des GND-Anschlusses am Bedienschalter SW1. Gleichzeitig kann diese LED-Leitung L3 zur Ansteuerung der LED's verwendet werden, so dass durch eine solche Doppelnutzung dieser Leitung eine Verdrahtungsleitung gespart werden kann.

Optional kann auf die Leuchtdiode LED verzichtet werden, jedoch ist dann trotzdem eine Leitung L3 zwischen dem Bedienschalter SW1 und dem Steuergerät ST1 erforderlich, wobei diese Leitung L3 in dem Bedienschalter SW1 auf Masse GND liegen würde.

Die Interfaceschaltungen IF1 und IF2 für den ersten und zweiten Kontaktzweig K1 und K2 sind identisch aufgebaut. Über einen jeweils mit der Signalleitung L1 bzw. L2 verbundenen Sensorwiderstand RS1 bzw. RS2 kann entweder über einen Schalter SI1.1 bzw. SI2.1 eine Prüfspannung U_{Prüf}, über einen Schalter SI1.2 bzw. SI2.2 die Bordnetzspannung U_{Batt} oder über einen Schalter SI1.3 bzw. SI2.3 die Masse GND gelegt werden. Ferner werden die Spannungen U1.1 und U1.2 bzw. U2.1 und U2.2 an den Sensorwiderständen RS1 und RS2 erfasst und von der Steuereinheit ST1 ausgewertet.

Die Interfaceschaltung IF3 besteht aus einem Schalter SI3.2 und einem Schalter SI3.3, die die Bordnetzspannung U_{Batt} bzw. die Masse GND über einen Sensorwiderstand RL1 auf die LED-Leitung L3 schalten. Die an dem Sensorwiderstand auftretenden Spannung U3.1 und U3.2 werden von dem Steuergerät ST1 erfasst und ausgewertet.

Bei ruhendem bzw. parkendem Fahrzeug werden zur Vermeidung unnötig hoher Verlustleistung und dementsprechender Entladung der Batterie Steuergeräte abgeschaltet; diese Abschaltung ist auch mit dem Steuergerät ST1 möglich, das eine Aufweckfunktion unterstützt. Die Sensorwiderstände RS1 bzw. RS2 des ersten bzw. zweiten Kontaktzweiges K1 bzw. K2 sind mit einem Wakeup-Eingang W1 bzw. W2 des Steuergerätes verbunden, so dass bei einer Betätigung des Bedienschalters SW1 in die "Apply"-Stellung das Steuergerät ST1 aus einem Standby-Zustand heraus geweckt werden kann, um die entsprechende Funktion ausführen zu lassen. Aufgrund des redundanten Aufbaus des Bedienschalters SW1 ist diese Wakeup-Funktion auch im Steuergerät ST1 redundant vorhanden, um ein den geltenden Vorschriften gemäßes Zuspannen aus dem Standby-Zustand heraus sicher zu gewährleisten.

Wird bspw. der Bedienschalter SW1 in Richtung seiner ersten Schaltstellung "Apply" betätigt, werden nur die Schaltkontakte S1.1 und S1.2 geschlossen, mit der Folge, dass die Bordnetzspannung U_{Batt} über den Schaltkontakt S1.1 und den Schutzwiderstand R1.1 sowie über den Schaltkontakte S1.2 und den Schutzwiderstand R1.2 auf die Signalleitung L1 bzw. L2 geschaltet wird, so dass an diesen beiden Sensorwiderständen RS1 und RS2 jeweils ein Wakeup-Signal erzeugt wird, um dadurch bspw. ein Wecksignal auf den Spannungsregler für die Prüfspannung U_{Prüf} zu schalten, oder, falls anstelle der Spannungsquellen Stromquellen verwendet werden, diese einzuschalten. Damit wird im Prinzip eine leckstromfreie Wakeup-Funktion für das Steuergerät ST1 bereitgestellt.

Damit fließt im Standby-Modus des Steuergerätes ST1 bei unbetätigtem Zustand des Bedienschalters SW1 kein Strom in den Signalleitungen L1 und L2, außer dem vernachlässigbaren Leckstrom durch die Dioden D1.1 und D1.2 der Diodeneinrichtungen DR1.1 und DR1.2. Damit liegt auf den Signalleitungen L1 und L2 im Standby-Modus kein positives Potential der Bordnetzspannung, so dass dort keine Leckströme oder Kriechströme hervorgerufen werden. Dies gilt auch für die LED-Leitung L3, da im Standby-Modus diese LED-Leitung L3 nicht angesteuert wird und daher auch auf keinem positiven Potential der Bordnetzspannung liegt.

Wenn das Steuergerät ST1 aus dem Standby-Modus aufgeweckt wurde, laufen verschieden Prozeduren zur Überprüfung des Bedienschalter SW1 und dessen Verkabelungen als auch ein Auslesen der Schalterstellungen ab. Diese Prozeduren können entweder fest nach einem vorgegebenen Schema ablaufen oder situativ, bspw. an die aktuelle Schalterstellung angepasst ablaufen.

Diese Überprüfung der Funktion des Schalters erfolgt durch systematisches Abfragen bzw. Beschalten mit verschiedenen Spannungen (oder Strömen) und Auswertung der Effekte über den Spannungsabfall an den Widerständen RS1, RS2 bzw. RS3 der Interfaceschaltungen IF1, IF2 und IF3.

Das kurzzeitige Beschalten der Signalleitungen L1 und L2 erfolgt mit verschiedenen Testspannungen oder Testströmen, wobei hierzu auch eine Prüfspannung U_{Prüf} als Testspannung verwendet wird, deren Wert über dem Wert der Bordnetzspannung U_{Batt} liegt, also |UPrüf|>|UBₐₜₜ| gilt und bspw. 22 V beträgt.

Das Beschalten mit Spannungspegeln unterhalb der Bordnetzspannung U_{Batt} führt bei unbetätigtem Bedienschalter SW1 zu einer Angleichung des Potentials auf der Signalleitung L1 oder L2 an das aufgeschaltete Potential. Als Reaktion hierauf folgen die jeweils anderen Leitungen L2 und L3 oder L1 und L3 im mit einem Potential beschalteten oder nicht beschalteten Zustand ihrem Sollpegel oder bleiben im Wesentlichen auf ihrem vorherigen Pegel. Bei einem solchen Test treten, bis auf im Wesentlichen durch kapazitive oder induktive Kopplungen hervorgerufene Ausgleichströme, keine nennenswerten Effekte auf.

Ein Kurzschluss auf einer der Signalleitungen L1 oder L2 gegen die Bordnetzspannung U_{Batt} wird durch die Steuereinheit ST1 detektiert. Ein Kurzschluss gegen eine der jeweils anderen Leitungen L2 oder L3 bzw. L1 oder L3 wird ebenso detektiert, da sich die hierfür vorgesehenen Testspannungen auch auf diese Leitungen L2 oder L3 bzw. L1 oder L3 auswirken und daher detektiert werden kann.

Die ordnungsgemäße Verbindung des Bedienschalters LW1 mit der Kl30, also dem positiven Potential der Bordnetzspannung U_{Batt} wird mit der bereits beschriebenen Prüfspannung U_{Prüf}, deren Wert größer ist als die Bordnetzspannung U_{Batt} ist, bspw. mittels des Schalters SI1.1 der Interfaceschaltung IF1 des Steuergerätes ST1 auf die Signalleitung L1 geschaltet. Wird dieser höhere Wert der Prüfspannung U_{Prüf} an der Diodeneinrichtung DR1.1 gegen die ggf. einen leichten Spannungsversatz von U_{Batt} an dem Steuergerät SW1 gegenüber der an das Steuergerät ST1 angeschalteten Spannungsversorgung U_{Batt} geschaltet, wirkt dieser Kontaktzweig K1 im Bedienschalter SW1 wie eine Stromsenke oder ein Spannungsteiler, dessen Effekt an der Messspannung U1.1 oder einem eingeprägten Strom I1 messbar ist. Damit kann ein ordnungsgemäßer Anschluss des Bedienschalters SW1 an der Bordnetzspannung U_{Batt} getestet bzw. überprüft werden, wobei hierbei keine Einflüsse auf die Signalleitung L2 entstehen. Entsprechendes gilt auch umgekehrt, wenn an die Signalleitung L2 die Prüfspannung U_{Prüf} gelegt wird.

Wird die Prüfspannung U_{Batt} in der Neutralstellung des Bedienschalters SW1 an den ersten Kontaktzweig K1 angelegt, zeigt die Messspannung U1.1 bei einem ordnungsgemäßen Anschluss an die Bordnetzspannung U_{Batt} einen Wert, der zwischen dem Wert der Prüfspannung U_{Prüf} und dem Wert der Bordnetzspannung U_{Batt} liegt, es gilt: U_{Batt} < U1.1< U_{Prüf}.

Wenn ein Abriss in der Neutralstellung des Bedienschalter SW1 vorliegt, ergibt sich: U1.1 = U_{Prüf}.

Liegt die Prüfspannung U_{Prüf} bei einem Abriss der Bordnetzspannung in der ersten Schaltstellung "Apply" des Bedienschalter SW1 auf der Signalleitung L1, so wird die Signalleitung L2 über in Serie geschalteten Schaltebenen E11 und E12 auf den Spannungspegel der Prüfspannung U_{Prüf} gezogen. Durch Beschalten mit den verschiedenen Lasten und daraus resultierenden Testspannungen oder Testströmen kann wiederum die Integrität des Zustands zuverlässig erkannt werden.

Durch geschickte Wahl der Widerstände R1.2, R1.3, R2.1 und R2.2, die teilweise auch unterschiedlich gewählt werden können, kann auch der Fall, dass die Bordnetzspannung U_{Batt} an dem Steuergerät SW1 niederohmig, also bspw. gegen Masse GND kurzgeschlossen ist, noch ausgewertet werden, obwohl hier über die Dioden D1.1 und D1.2 der Diodeneinrichtungen DR1.1 und DR1.2 und zusätzlich betätigten Bedienschalter SW1 ein Ableitstrom gegen die Masse GND fließen kann. In diesem Fehlerfall kann die Wakeup-Funktion über den Bedienschalter SW1 nicht mehr ausgeführt werden.

Entsprechend kann die Prüfung auch auf der Signalleitung L2 durchgeführt werden.

Weiterhin wird auch die Anbindung des Bedienschalters SW1 an den Masse-Anschluss, also an die Masse GND durch kurzfristiges Aufschalten einer Testspannung oder eines Stromes auf die LED-Leitung L3 geprüft, wobei ein solcher Strom durch den Widerstand R_{LED} und den Widerstand der Leuchtdiode LED begrenzt wird.

Wird der Masse-Anschluss GND des Bedienschalters SW1 abgerissen, so kann gemäß Figur 1 durch die antiparallel zur Leuchtdiode LED geschalteten Diode D3 entweder in Reihe zu dem Widerstand R_{LED} oder parallel zur Leuchtdiode LED und dem Widerstand R_{LED} durch Beschaltung der LED-Leitung L3, z.B. mit dem Masse-Pegel GND eine hinreichende Masse für den Bedienschalter SW1 erzeugt werden, so dass noch ein hinreichend zuverlässiges Schaltersignal erkannt werden kann.

Wird der Bedienschalter SW1 in seine erste Schaltstellung "Apply" betätigt, so wird über den Widerstand R1.1 des Schaltkontaktes S1.1 der Pegel des positiven Potentials der Bordnetzspannung auf die Signalleitung L1 geschaltet. Das Steuergerät ST1 kann nun seinerseits durch Aufschalten von verschiedenen Spannungen oder Strömen z.B. GND oder U_{Prüf} mittels der Schalter in den Interfaceschaltungen IF1 und IF2 testen, ob die Einflüsse des Schutzwiderstands R1.1 korrekt sind und ob irgendwelche Leitungsschlüsse, z.B. gegen die Signalleitung L2 vorliegen. Bei diesem Vorgang kann während der Bedienschalter SW1 in dessen ersten Schaltstellung "Apply" betätigt ist, die Stromrichtung gewechselt werden bzw. auch der Stromfluss zeitweilig abgeschaltet werden.

Mit der Signalleitung L2 wird entsprechend verfahren, wobei vorzugsweise nicht die identische Beschaltung oder nicht fortwährend gleichzeitig auf den Signalleitungen L1 und L2 Prüfspannungen angeschaltet werden.

Während einer Betätigung des Bedienschalters SW1 in die zweite Schaltstellung "Release" kann die Unabhängigkeit der Signalleitungen L1 und L2, dass also kein Leitungsschluss vorliegt, ebenso durch zeitlich unterschiedliches Ansteuern erkannt werden. Der bei kleineren aufgeschalteten Spannungen, z.B. 5V, 10V oder, wie in Figur 1 dargestellt, 14V, auftretende Ableitstrom lässt bereits eine klare Unterscheidung zu.

Eine Überwachung des ordnungsgemäßen Anschlusses der Bordnetzspannung U_{Batt} am Bedienschalter SW1 ist erforderlich, um ein Aufwecken des Steuergerätes ST1 im Bedarfsfall sicherzustellen und um bei einem Kurzschluss der auf der Signalleitung L1 liegenden Bordnetzspannung U_{Batt} gegen z.B. Masse GND und bei einem laufenden Steuergerät ST1 keine falschen Schlüsse aus den Pegeln der Signalleitungen L1 und L2 zu ziehen. Um eine mehrfache Sicherheit gegen einen gegen die Masse GND kurzgeschlossene Signalleitung L1 oder L2, welche auf der Bordnetzspannung U_{Batt} liegt, zu erreichen, können zusätzlich zu den beschriebenen Test unterschiedliche Widerstandswerte in den Interfaceschaltungen I1 und I2 eingesetzt werden.

Ein solcher Bedienschalter SW1 gemäß Figur 1 benötigt statt 5 Leitungen, wie im Stand der Technik bekannt, lediglich drei Leitungen L1, L2 und L3 für den Anschluss an das Steuergerät ST1, um eine gegenüber Einzelfehlern fehlertolerante Erkennung des jeweiligen Schaltzustands des Bedienschalter SW1 durch das Steuergerät ST1 zu ermöglichen, wobei zwei Leitungen Signalleitungen, nämlich L1 und L2 sind und die dritte Leitung L3 als LED-Leitung der Leuchtdiodenansteuerung und Testunterstützung dient. Auf die Leuchtdiode LED könnte verzichtet werden, wobei dann aber der Bedienschalter SW1 und das Steuergerät ST1 über eine zusätzliche Leitung L3 verbunden werden müssten.

Für den Bedienschalter SW1 nach Figur 1 werden ausschließlich normal geöffnete Schließkontakte S1.1, S.2, S2.1 und S2.2 verwendet, womit aufwändige Wechselschalter oder die Kombination von normal geöffneten und normal geschlossenen Schließkontakten entfallen. So können diese Schaltkontakte als Elastomer-Schaltmatten oder platzsparende Federelemente, wie z.B. Blattfederelemente ausgeführt werden, welche bei Betätigung den Kontakt herstellen. Somit können besonders einfache und preiswerte Schaltkontakte verwendet werden.

Schließlich werden für den Bedienschalter SW1 einfache Bauteile wie Widerstände und Dioden verwendet, die den Schutz der Schaltkontakte gewährleisten, wenn fälschlich z.B. die Bordnetzspannung U_{Batt} direkt an die Schaltkontakte angelegt wird.

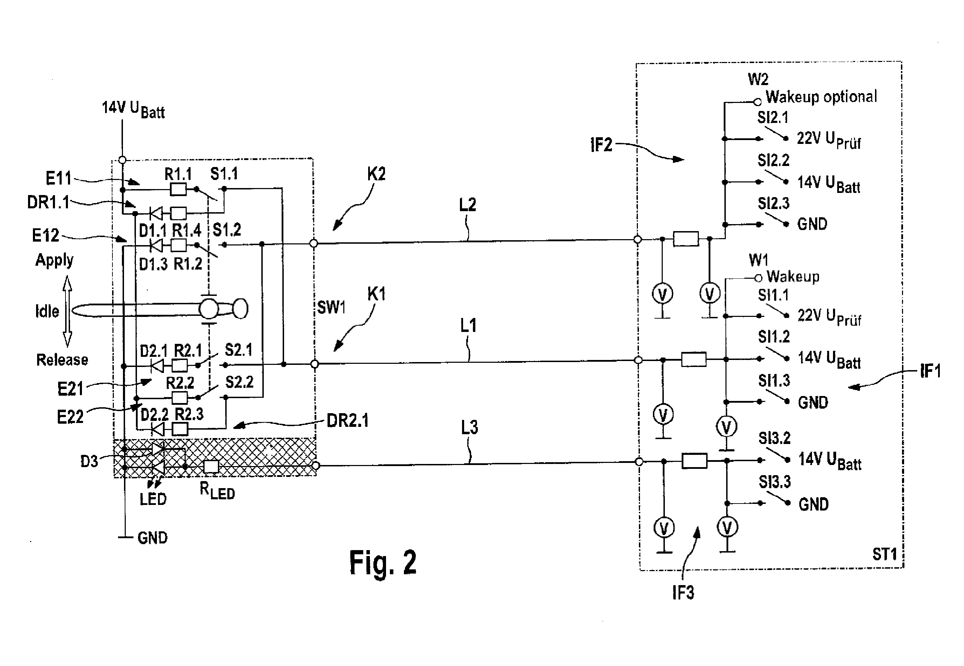

Die Schaltungsanordnung nach Figur 2 unterscheidet sich von derjenigen nach Figur 1 durch eine andere Verschaltung der parallelen Schaltebenen E11 und E12 bzw. E21 und E22 in der ersten bzw. zweiten Schaltstellung des Bedienschalter SW1. Die Interfaceschaltungen IF1, IF2 und IF3 des Steuergerätes ST1 unterscheiden sich nicht von denjenigen nach Figur 1. Auch die Verschaltung einer Leuchtdiode LED mit einem Schutzwiderstand R_{LED} und einer antiparallel zur Leuchtdiode LED geschalteten Diode D3 zur alternativen Masse-Anbindung an das Steuergerät ST1 und deren Anbindung an dasselbe ist gegenüber Figur 1 nicht verändert.

Gemäß Figur 2 ist der Kontaktzweig K identisch wie in Figur 1 ausgeführt. Dagegen ist die zweite Schaltebene E12 in der ersten Schaltstellung des Bedienschalter SW1 zur Bildung des zweiten Kontaktzweiges K2 nicht an die Bordnetzspannung U_{Batt}, sondern an das Bezugspotential, also an Masse GND angeschlossen. Entsprechend ist die zweite Schaltebene E22 in der zweiten Schaltstellung des Bedienschalters SW1 nicht mit der Masse GND, sondern mit der Bordnetzspannung U_{Batt} verbunden.

Bei dieser Ausführungsform des Bedienschalters SW1 ist in der ersten Schaltstellung "Apply" die Wakeup-Funktion nur ein Mal realisiert, da nur die Schaltebene E11 mit der Bordnetzspannung U_{Batt} verbunden ist. Da jedoch die zweite Schaltebene E22 in der zweiten Schaltstellung des Bedienschalters SW1 jetzt auf das positive Potential der Bordnetzspannung U_{Batt} gelegt wird, ist in dieser Schaltstellung "Release" eine optionale Wakeup-Funktion realisierbar. Das besondere an dieser Ausführungsform des Bedienschalters SW1 gemäß Figur 2 ist die "gegenläufige" Beeinflussung der Signalleitung L1 und L2 bei Betätigung des Bedienschalters SW1.

Die mit diesem Bedienschalter SW1 gemäß Figur 2 durchführbaren Testprozeduren, insbesondere mit der Prüfspannung U_{Prüf}, welche größer ist als der Wert der Bordnetzspannung, entspricht denjenigen im Zusammenhang mit der Schaltungsanordnung gemäß Figur 1 besprochenen.

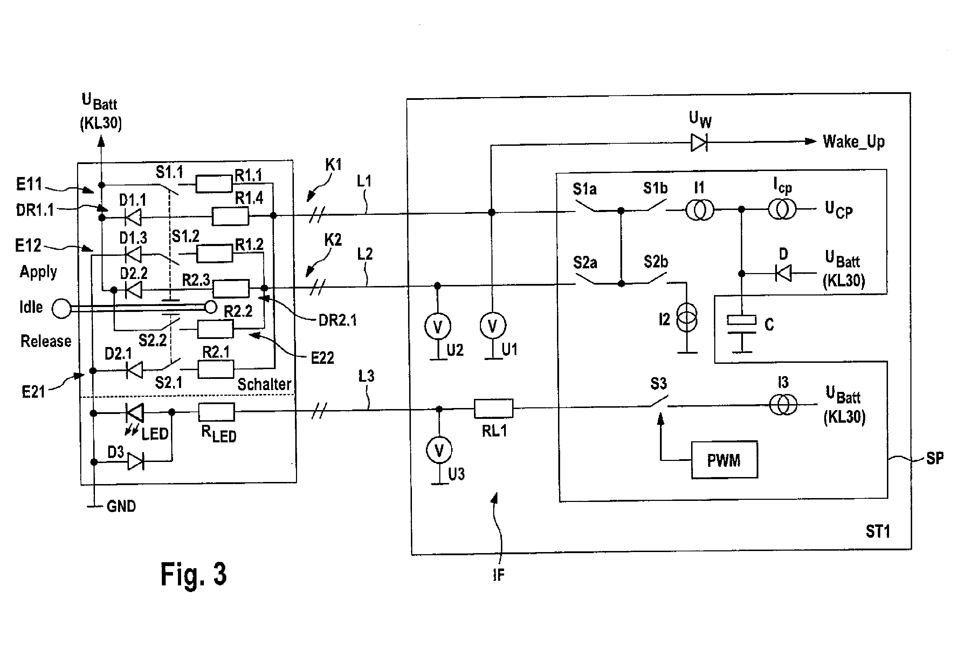

Die Schaltungsanordnung nach Figur 3 entspricht hinsichtlich ihrer Struktur derjenigen von Figur 2, bei der die beiden Signalpfade K1 und K2 "gegenläufig" geschaltet sind, unterscheidet sich jedoch im Aufbau der Schnittstellenschaltungen I1, I2 und I3 des Steuergerätes ST1. Nach Figur 3 weist die Schnittstellenschaltung IF eine Spannungserzeugungseinheit SP auf, die mit Stromquellen aufgebaut ist.

Die Signalleitung L1 des ersten Kontaktzweiges K1 ist über eine Reihenschaltung eines Schalters S1a und S1b über seriell verschaltete Stromquellen I1 und I_{cp} an eine die Prüfspannung U_{Prüf} darstellende Spannungsquelle U_{CP} angeschlossen. Die Verbindungsleitung zwischen den beiden Stromquellen I1 und I_{cp} ist einerseits an einen Kondensator C und andererseits über eine in Durchlassrichtung geschalteten Diode D an die Bordnetzspannung U_{Batt} (Kl30) angeschlossen. Der Spannungspegel auf der Signalleitung L1 wird durch eine Messspannung U1 bestimmt.

Die Signalleitung L2 des zweiten Kontaktzweiges K2 ist über zwei seriell verschaltete Schalter S2a und S2b mit einer Stromquelle I2 verbunden. Die jeweils seriell geschalteten Schalter S1a und S1b bzw. S2a und S2b sind miteinander verbunden. Der Spannungspegel auf der Signalleitung L2 wird durch eine Messspannung U2 bestimmt.

Die LED-Leitung L3 ist über einen Widerstand RL1, einen Schalter S3 und eine Stromquelle I3 mit der Bordnetzspannung U_{Batt} (Kl30) verbunden, wobei der Schalter S3 zur Ansteuerung der Leuchtdiode LED des Bedienschalters SW1 mit einer Schaltung zur Pulsweitenmodulation verbunden ist.

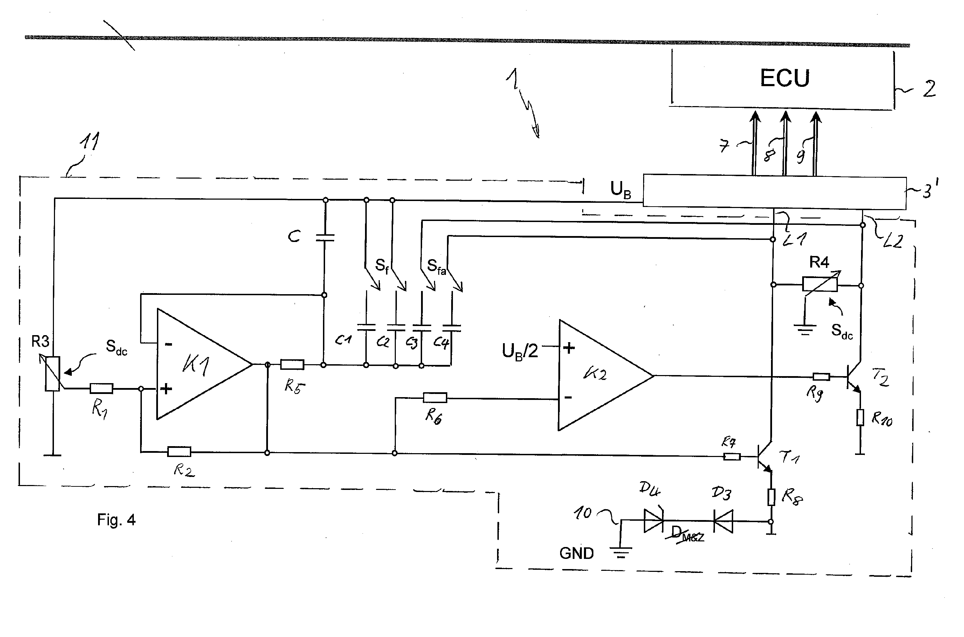

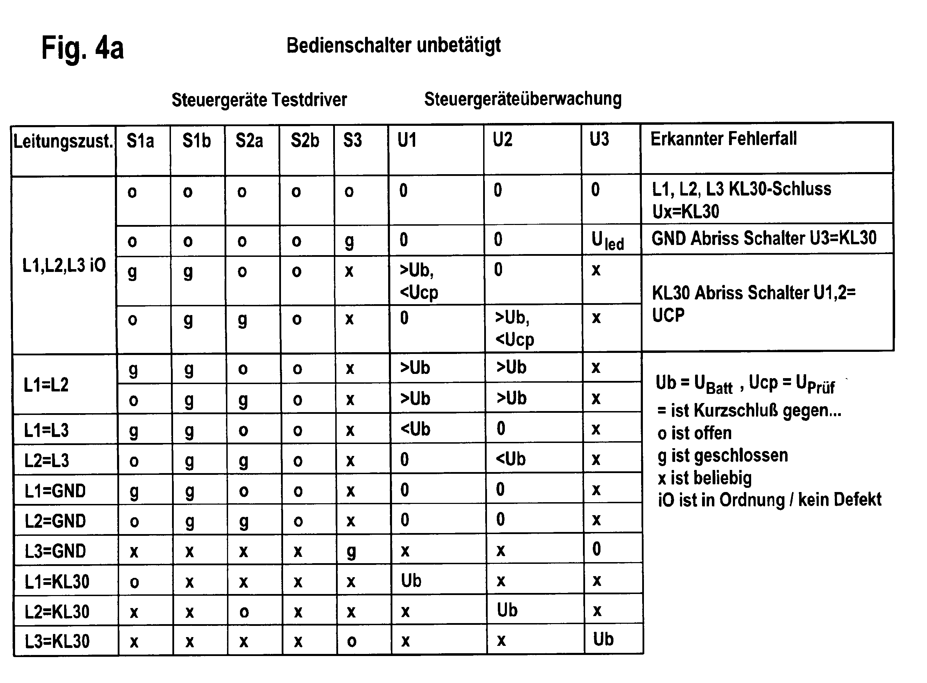

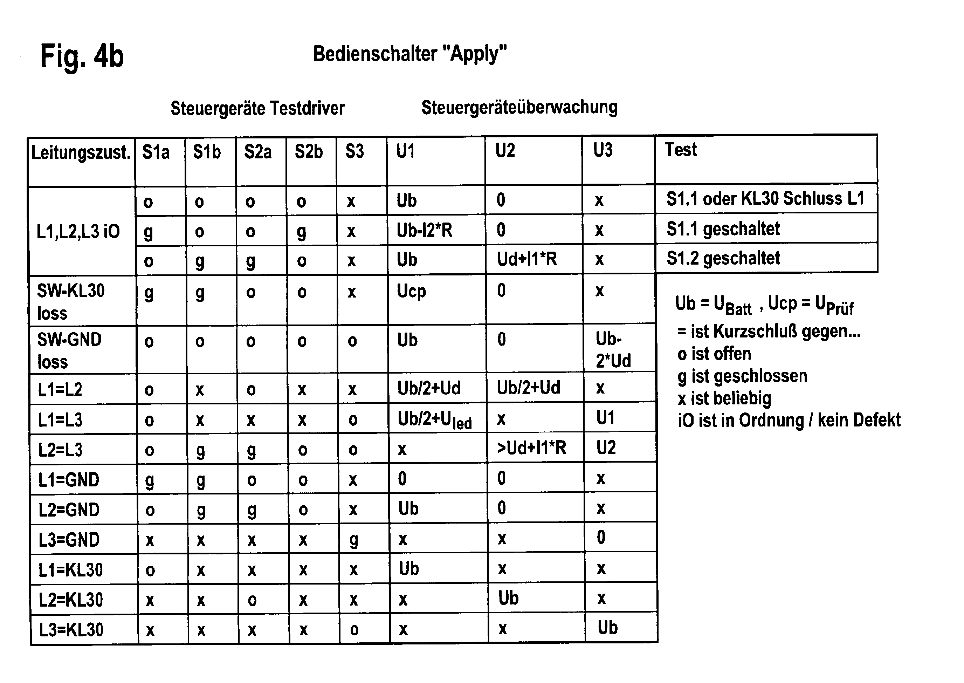

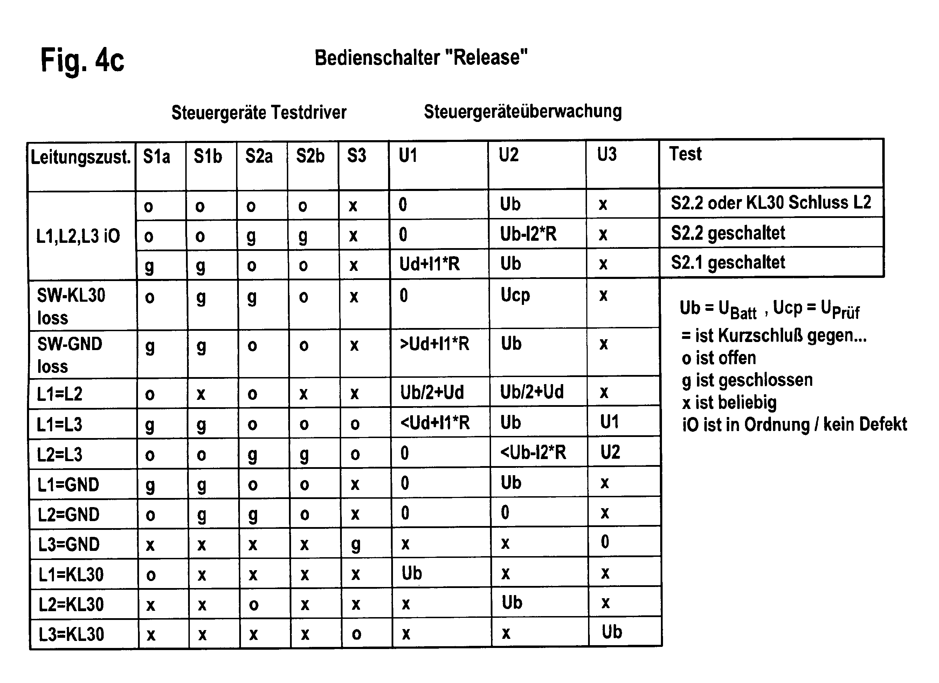

Die von dem Steuergerät ST1 durchgeführten Testprozeduren zur Fehlererkennung und Funktionsüberwachung für alle Schaltstellungen des Bedienschalters SW1, also für die Neutralstellung, die erste Schaltstellung "Apply" und die zweite Schaltstellung "Release" ist den Tabellen gemäß den Figuren 4a, 4b und 4c gezeigt.

Beispielhaft werden aus diesen Tabellen die Fälle erläutert, in denen ein Abriss des Bedienschalters SW1 nach Figur 3 mittels einer Prüfspannung U_{Prüf} bzw. U_{cp} überprüft wird.

Die Tabelle nach Figur 4a zeigt die Testprozeduren, wenn der Bedienschalter SW1 unbetätigt, sich also in seiner Neutralstellung befindet. Um einen Abriss des Bedienschalters SW1 von dem Anschluss der Bordnetzspannung U_{Batt} (in den Figuren 4a, 4b und 4c entspricht U_{b} = U_{Batt}), also von der Klemme 30 zu erkennen, gibt es zwei Prozeduren (vgl. 4. und 5. Zeile).

Gemäß dem ersten Test werden die Schalter S1a und S1b geschlossen, während die beiden Schalter S2a und S2b offen bleiben, wobei der Schalter S3 eine beliebige Stellung einnehmen kann. In diesem Fall liegt die Prüfspannung U_{cp} auf der Signalleitung L1, so dass bei ordnungsgemäßer Anbindung der ersten Schaltebene E11 das Potential auf der Signalleitung L1 zwischen der Bordnetzspannung U_{Batt} und der Prüfspannung U_{cp} liegt, da es eine den Schaltkontakt S1.1 überbrückende Verbindung über die Diodeneinrichtung DR1.1 zu der Bordnetzspannung U_{Batt} gibt.

Es gilt somit: U_{Batt} < U1 < U_{cp}. Die Messspannung U2 an der Signalleitung L2 ist dagegen Null, da der Schaltkontakt S1.2 offen und ebenso die beiden Schalter S2a und S2b offen sind.

Im Fehlerfall, also bei abgerissener Anbindung an die Bordnetzspannung U_{Batt} gäbe es keine Verbindung mehr zur Klemme 30, also läge das Potential auf der Signalleitung L1 auf dem Pegel des Prüfsignals U_{cp}.

Gemäß dem zweiten Test sind die beiden Schalter S1b und S2a geschlossen, während die beiden anderen Schalter S1a und S2b offen bleiben. Dadurch liegt die Prüfspannung U_{cp} an der Signalleitung L2 an, so dass wie im ersten beschriebenen Fall aufgrund der Verbindung der Diodeneinrichtung DR2.1 der ersten Schaltebene der zweiten Schaltstellung des Bedienschalters SW1 eine Verbindung zur Bordnetzspannung U_{Batt} herstellt und damit für den Pegel auf der Signalleitung L2 ebenso gilt: U_{Batt} < U2 < U_{cp}.

Die Messspannung U1 an der Signalleitung L1 ist dagegen Null, da der Schaltkontakt S1.1 offen und ebenso die beiden Schalter S1a und S2b offen sind.

Befindet sich der Bedienschalter SW1 in seiner ersten Schaltstellung "Apply", so wird ein Abriss von der Bordnetzspannung U_{Batt} gemäß Tabelle nach Figur 4b dadurch geprüft (vgl. Zeile 5), dass die Schalter S1a und S1b geschlossen sind, während die beiden anderen Schalter S2a und S2b offen sind. Die Schaltstellung des Schalters S3 ist beliebig. Bei Abriss dieser Anbindung an die Bordnetzspannung U_{Batt} stellt sich der Pegel auf der Signalleitung L1 auf die Prüfspannung U_{cp} ein, es gilt U1= U_{cp}. Die Messspannung U2 zeigt den Wert Null.

Entsprechend kann auch in der zweiten Schaltstellung "Release" des Bedienschalters SW1 nach Tabelle gemäß Figur 4c ein Abriss von der Bordnetzspannung U_{Batt} erkannt werden (vgl. Zeile 5). Hierzu werden die Schalter S1b und S2a geschlossen, während die beiden anderen Schalter S1a und S2b offen bleiben, so dass nur auf die Signalleitung L2 die Prüfspannung U_{cp} anliegt. Da von der Signalleitung L2 keine Verbindung zur Klemme 30 besteht, stellt sich auf dieser Leitung L2 der Pegel auf die Prüfspannung U_{cp} ein, es gilt U2=U_{cp}. Die Messspannung U1 zeigt den Wert Null.

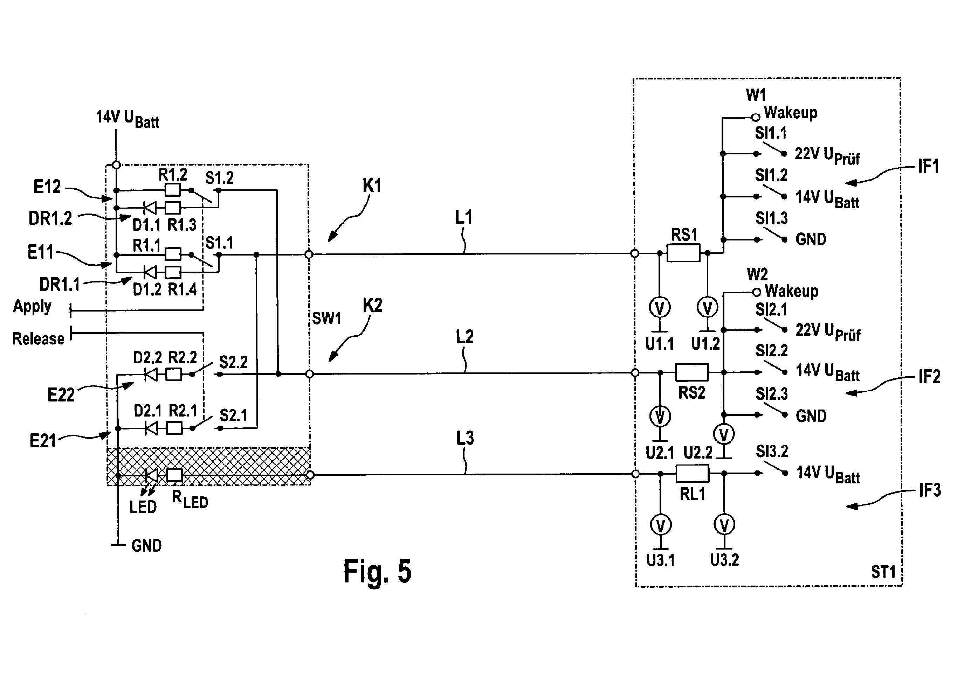

Die Schaltungsanordnung nach Figur 5 zeigt einen Bedienschalter SW1 als Parkbremsschalter, der in seiner ersten und zweiten Schaltstellung entsprechend dem Bedienschalter SW1 nach Figur 1 jeweils mit zwei Schaltebenen E11 und E12 bzw. E21 und E22 ausgebildet ist, jedoch im Unterschied zu Figur 1 keine Verriegelung aufweist und mit zwei Tastern ausgebildet ist.

Ferner fehlt auch die Diode D3 zur Herstellung eines GND-Anschlusses über das Steuergerät ST1, wenn ein Abriss des Masseanschlusses des Bedienschalters SW1 vorliegen würde. Die Testprozeduren entsprechen denjenigen, die im Zusammenhang mit Figur 1 beschrieben wurden.

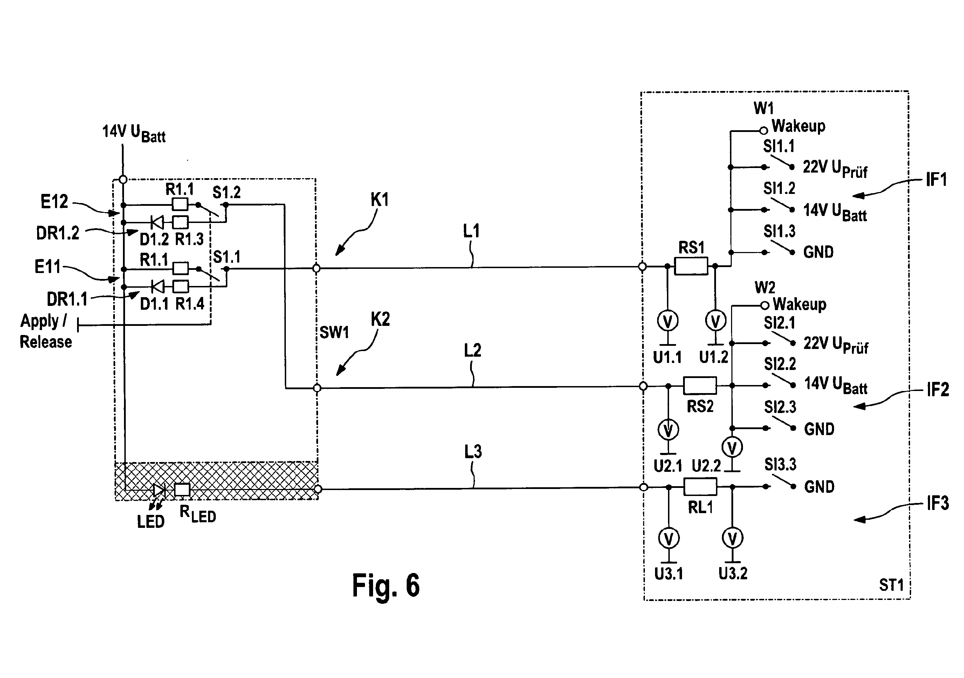

Die Schaltungsanordnung nach Figur 6 zeigt einen Bedienschalter SW1 als Parkbremstastschalter, der nur aus einem Taster mit einer ersten Schaltstellung als einzigen Schaltstellung ausgebildet ist, wobei diese einzige Schaltstellung zwei parallele Schaltebenen E11 und E12 aufweist, die entsprechend den Schaltebenen E11 und E12 des Bedienschalters SW1 nach Figur 1 zur Bildung eine ersten Kontaktzweiges K1 und K2 über Signalleitungen L1 und L2 mit einem Steuergerät ST1 verbunden sind. Der unbetätigte Zustand dieses Tasters SW1 entspricht der Neutralstellung des Bedienschalters SW1 nach Figur 1.

Auch ist dieser Bedienschalter SW1 mit einer Leuchtdiode LED und einem Schutzwiderstand R_{LED} ausgebildet, einenends an die Bordnetzspannung U_{Batt} angeschlossen und andernends über eine LED-Leitung L3 sowie die Schnittstellenschaltung I3 mit dem Bezugspotential der Bordnetzspannung U_{Batt}, also der Masse GND verbindbar.

Die Testprozeduren, insbesondere mit einer Prüfspannung U_{Prüf} sind entsprechend denjenigen im Zusammenhang mit Figur 1 erläuterten identisch.

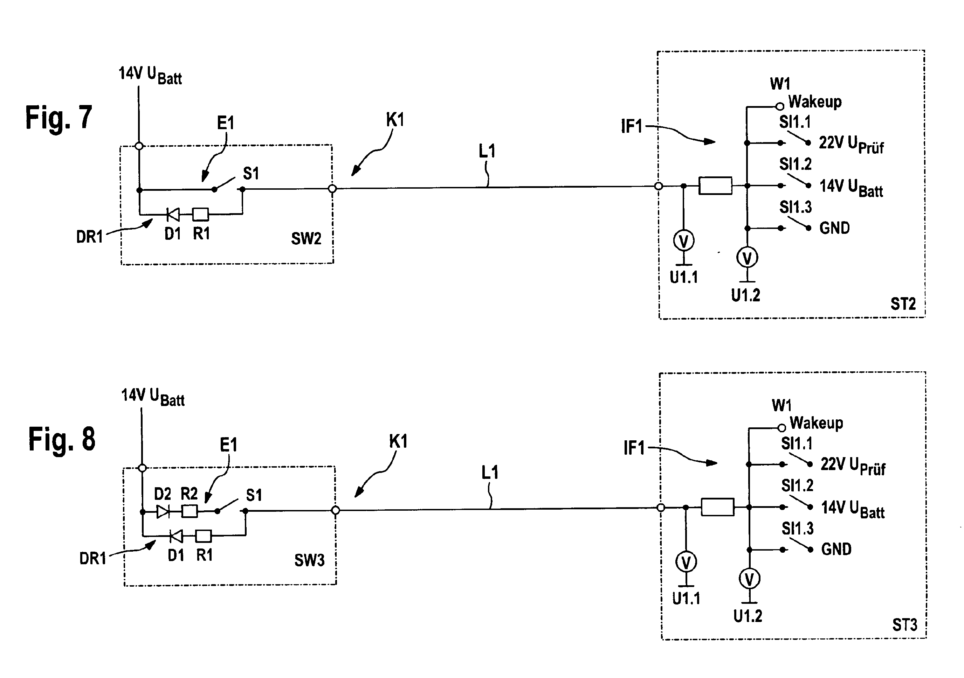

Die Schaltungsanordnung nach Figur 7 zeigt einen einfachen Bedienschalter SW2 ohne redundante Schaltebenen, besteht also nur aus einer einzigen an die Bordnetzspannung U_{Batt} angeschlossenen Schaltebene E1, die über eine Signalleitung L1 mit einem Steuergerät ST2 verbunden ist, welches nur eine einzige Schnittstellenschaltung IF1 aufweist, die derjenigen IF1 gemäß des Steuergerätes ST1 nach Figur 1 entspricht.

Die einzige Schaltebene E1 besteht aus einem Schaltkontakt S1, der von einer Diodeneinrichtung DR1 überbrückt wird und somit den in Figur 1 beschriebenen Diodeneinrichtung DR1.1 entspricht, also aus einer Reihenschaltung einer Diode D1 und eines Widerstandes R1 besteht, wobei die Diode D1 hinsichtlich der Bordnetzspannung U_{Batt} in Sperrrichtung geschaltet ist.

Dieser einfache Bedienschalter SW2 stellt einen leckstromfreien Schaltereingang zur Verfügung, dessen Verdrahtung zur Bordnetzspannung U_{Batt} ebenso wie beim Bedienschalter SW1 nach Figur 1 mit einer Prüfspannung U_{Prüf}, deren Wert über dem Wert der Bordnetzspannung U_{Batt} liegt, überprüft werden. Das von diesem Bedienschalter SW2 erzeugt Signal ist wakeup-fähig.

Ein ebenso dem Bedienschalter SW2 nach Figur 7 entsprechenden Bedienschalter SW3 zeigt Figur 8, jedoch weist dieser Bedienschalter SW3 im Unterschied zum Bedienschalter SW2 nach Figur 7 eine in Reihe zum Schaltkontakt S1 geschalteten Widerstand R2 und eine in Durchlassrichtung gepolte Diode D2 auf. Aufgrund dieser zusätzlichen Beschaltung mit dem Widerstand R2 und der Diode D2 lässt sich ein Test mittels des Steuergerätes ST3 durchführen, mit dem ein Kurzschluss der Signalleitung L1 gegen die Bordnetzspannung U_{Batt} erkannt wird.

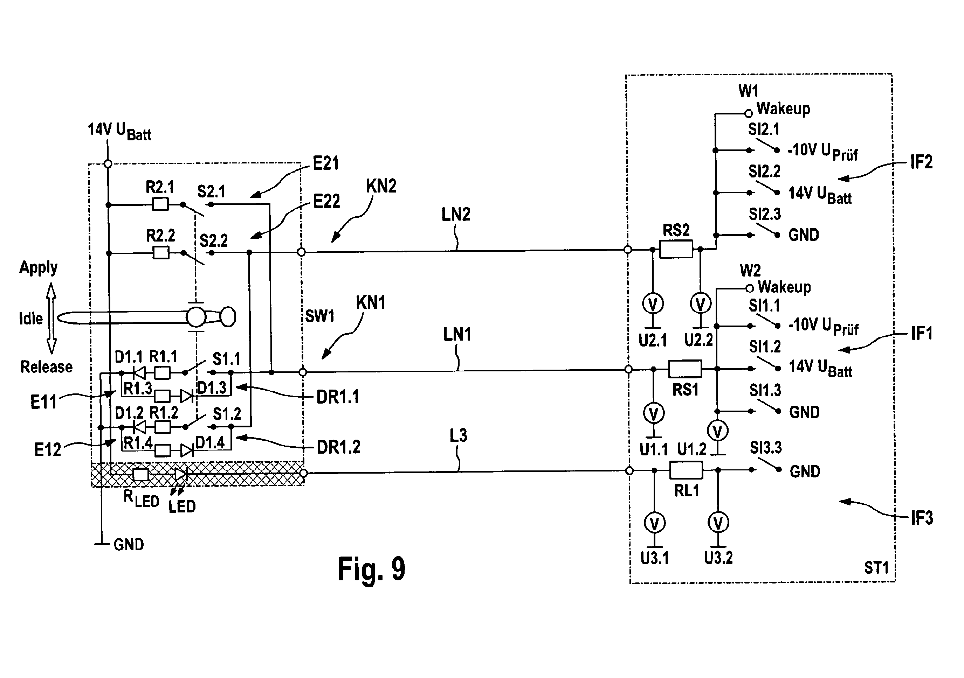

Die Schaltungsanordnung nach Figur 9 zeigt gegenüber derjenigen nach Figur 1 eine alternative Ausführung hinsichtlich der Prüfspannung U_{Prüf}, deren Wert nicht größer als der Wert des positiven Potentials der Bordnetzspannung U_{Batt} ist, sondern eine gegenüber der Bezugsspannung der Bordnetzspannung U_{Batt}, also gegenüber der Masse GND negativ ist, also nicht wie in den anderen Ausführungsbeispielen bspw. +22 V beträgt sondern bspw. -10 V. Dies führt zu einer anderen Struktur innerhalb des Bedienschalters SW1, wie in Figur 9 dargestellt ist.

Dieser Bedienschalter SW1 nach Figur 9 weist ebenso zwei Schaltstellungen "Apply" und "Release" sowie eine Neutralstellung auf, wobei beide Schaltstellungen jeweils mit redundanten Schaltebenen E11 und E12 bzw. E21 und E22 ausgebildet sind.

Die "Release"-Stellung wird im Zusammenhang mit der Beschreibung der Figur 9 als erste Schaltstellung und die "Apply"-Stellung als zweite Schaltstellung des Bedienschalters SW1 bezeichnet.

Der Bedienschalter SW1 als Parkbremsschalter ist über zwei Signalleitungen LN1 und LN2 sowie einer LED-Leitung L3 mit einem Steuergerät, bspw. ein Parkbremssteuergerät als Auswerteeinheit ST1 verbunden. Die Anbindung dieser Leitungen LN1, LN2 und L3 an das Steuergerät ST1 erfolgt jeweils über eine Interfaceschaltung IF1, IF2 und IF3 entsprechend derjenigen nach Figur 1 mit dem Unterschied, dass die Prüfspannung U_{Prüf} negativ ist und die LED-Leitung L3 über einen Schalter SI3.3 nur mit der Masse GND der Bordnetzspannung U_{Batt} verbindbar ist.

Jeder der Schaltebenen E11 und E12 bzw. E21 und E22 des Bedienschalters SW1 besteht aus einem Schließer S1.1 und S1.2 bzw. S2.1 und S2.2 als Schaltkontakt, denen jeweils ein Schutzwiderstand R1.1 und R1.2 bzw. R2.1 und R2.2 in Reihe geschaltet ist. Ferner sind in Reihe zu den Widerständen R1.1 und R1.2 der beiden Schaltebenen E11 und E12 in der ersten Schaltstellung jeweils eine Diode D1.1 und D1.2 in Durchlassrichtung geschaltet.

Die beiden Schaltebenen E11 und E12 in der ersten Schaltstellung "Release" sind einenends auf das Bezugspotential GND der Bordnetzspannung U_{Batt}, also auf Masse GND gelegt und andernends ist die Schaltebene E11 bzw. E12 zur Bildung eines ersten bzw. zweiten Kontaktzweiges KN1 bzw. KN2 mit der Signalleitung LN1 bzw. LN2 verbunden, die ihrerseits an die Interfaceschaltung IF1 bzw. IF2 des Steuergerätes ST1 angeschlossen sind.

Ferner werden diese beiden Schaltebenen E11 und E12 jeweils von einer Diodeneinrichtung DR1.1 bzw. DR1.2 überbrückt, die aus in Serie geschalteten Diode D1.3 und R1.3 bzw. D1.4 und R1.4 aufgebaut ist, wobei die beiden Dioden D1.3 und D1.4 jeweils bezgl. der Bordnetzspannung U_{Batt} in Sperrrichtung gepolt sind.

Die beiden Schaltebenen E21 und E22 der zweiten Schaltstellung "Apply" sind einenends mit dem positiven Potential der Bordnetzspannung U_{Batt}, verbunden und andernends auf den ersten bzw. zweiten Kontaktzweig KN1 bzw. KN2 geführt und dort mit der ersten bzw. zweiten Schaltebene E11 bzw. E22 verbunden.

Desweiteren weist der Bedienschalter SW1 eine Leuchtdiode LED auf, die über die LED-Leitung L3 mit der Interfaceschaltung IF3 des Steuergerätes ST1 verbunden ist und von diesem zur Anzeige des Zustandes der mit dem Bedienschalter betätigbaren Funktion (d. h. Parkbremse angezogen oder gelöst) angesteuert wird. Diese Leuchtdiode LED ist direkt über einen Schutzwiderstand R_{LED} mit der Bordnetzspannung U_{Batt} verbunden.

Die Überprüfung der Funktion des Bedienschalters SW1 gemäß Figur 9 sowie die Detektion der Schalterstellungen erfolgt identisch wie im Zusammenhang mit der Schaltungsanordnung nach Figur 1 beschrieben wurde, also durch systematisches Abfragen bzw. Beschalten mit verschiedenen Spannungen (oder Strömen) und Auswertung der Effekte über den Spannungsabfall an den Widerständen RS1, RS2 bzw. RS3 der Interfaceschaltungen IF1, IF2 und IF3.

Das kurzzeitige Beschalten der Signalleitungen LN1 und LN2 erfolgt mit verschiedenen Testspannungen oder Testströmen, wobei hierzu auch die Prüfspannung U_{Prüf} als Testspannung verwendet wird, deren Wert, wie bereits ausgeführt, negativ gegenüber dem Bezugspotential GND der Bordnetzspannung U_{Batt}, also der Masse ist, um damit bspw. ebenso einen Abriss des Bedienschalters SW1 von dem positiven Potential der Bordnetzspannung U_{Batt} zu detektieren.

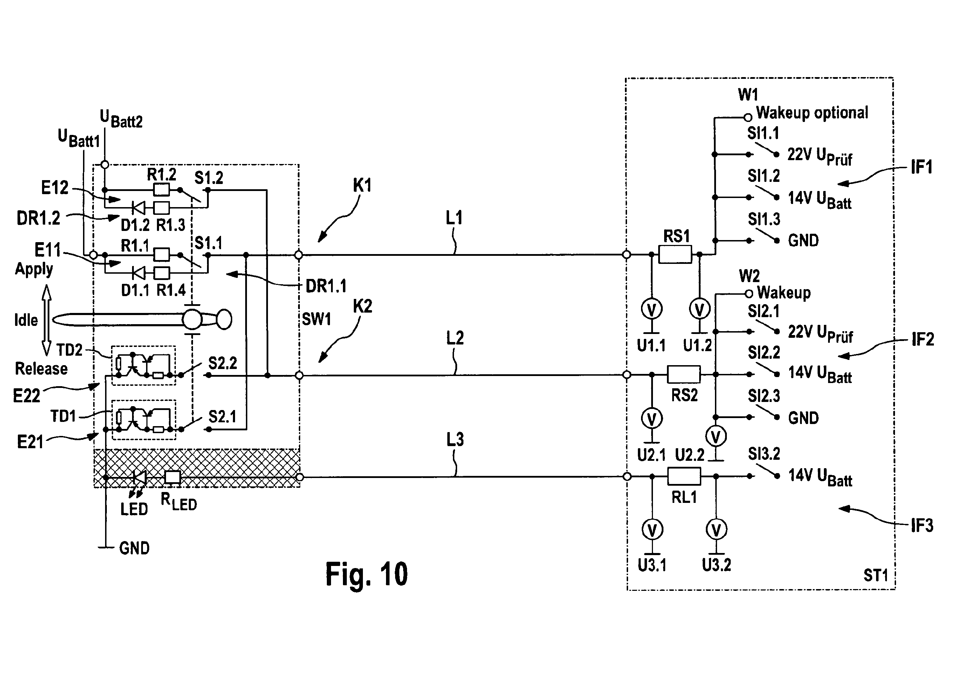

Die Schaltungsanordnung nach Figur 10 ist im Prinzip identisch mit derjenigen nach Figur 1, jedoch mit den Unterschieden, dass zwei Versorgungspannungen für den Bedienschalter SW1 vorgesehen sind und die Schaltebenen E21 und E22 in der zweiten Schaltstellung anstelle der Dioden D2.1 und D2.2 Diodenersatzschaltungen TD1 und TD2 eingesetzt werden. Diese Diodenersatzschaltungen TD1 und TD2 sind mit zwei Transistoren und zwei Widerständen in dem Fachmann bekannter Weise aufgebaut. Auch die Dioden der in den anderen Figuren dargestellten Bedienschalter SW1 können ganz oder teilweise durch solche Diodenersatzschaltungen ersetzt werden.

Ferner fehlt bei dem Bedienschalter SW1 nach Figur 10 für einen Ersatz eines GND-Anschlusses eine antiparallel zur Leuchtdiode LED geschaltete Diode D3.

Bei diesem Bedienschalter SW1 nach Figur 10 ist der erste Schaltungszeig E11 an eine erste Bordnetzspannung U_{Batt1} und der zweite Schaltungszweig E12 an eine zweite Bordnetzspannung U_{Batt2} angeschlossen.

Mit einer solchen redundanten Spannungsversorgung des Bedienschalters SW1 wird dessen Verfügbarkeit verbessert. Jede dieser Bordnetzspannungen U_{Batt1} und U_{Batt2} wird separat auf Abriss von dem Bedienschalter SW1 mittels der jeweils auf die Signalleitung L1 und L2 gelegten Prüfspannung U_{Prüf} geprüft, wie dies im Zusammenhang mit des Schaltungsanordnung nach Figur 1 erläutert wurde. Eine solche redundante Spannungsversorgung kann auch in den anderen erläuterten Schaltungsanordnungen realisiert werden.

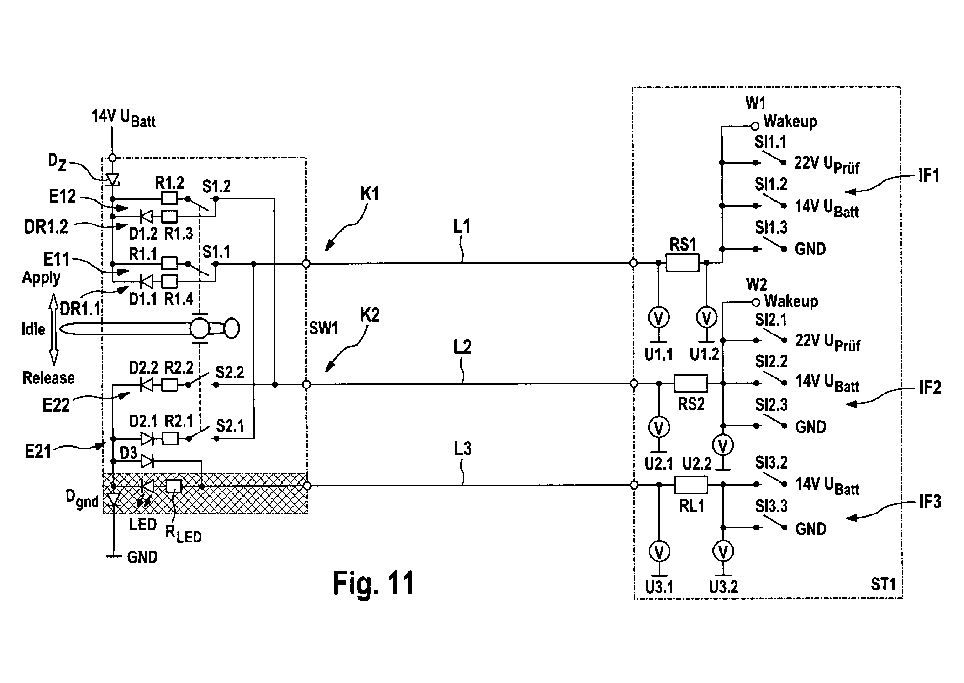

Die Schaltungsanordnung nach Figur 11 ist im Prinzip identisch mit derjenigen nach Figur 1, jedoch weist der Bedienschalter SW1 eine Zener-Diode D_{Z} in der Zuleitung der Bordnetzspannung U_{Batt} für die beiden Schaltebenen E11 und E12 der ersten Schaltstellung "Apply" auf (sowie eine in der Verbindungsleitung zur Masse GND geschaltete Diode D_{gnd}), welche es erlaubt, bei einem Kurzschluss der Bordnetzspannung U_{Batt} gegen die Masse GND eine interne Spannungsversorgung des Bedienschalters SW1 über die jeweils andere Signalleitung L1 oder L2 sicherzustellen und gleichzeitig auch die Durchführung von Überprüfungstests an dem Bedienschalter SW1, vor allem mit der Prüfspannung U_{Prüf} vorzunehmen. Das letztgenannte wird dadurch möglich, dass der Wert der Prüfspannung U_{Prüf} größer als die Zenerspannung U_{Z} dieser Zener-Diode D_{Z} ist.

Ferner wird mit diesem Bedienschalter SW1 nach Figur 11 eine doppelte Masse-Versorgung sichergestellt, nämlich einmal über den Anschluss der Masse GND am Bedienschalter SW1 und zum anderen zusätzlich über die LED-Leitung L3, die mittels des Schalters SI3.3 der Interfaceschaltung IF3 des Steuergerätes ST1 aufgeschaltet werden kann.

Die Überprüfung der Funktion des Bedienschalters SW1 gemäß Figur 11 sowie die Detektion der Schalterstellungen erfolgt identisch wie im Zusammenhang mit der Schaltungsanordnung nach Figur 1 beschrieben wurde, also durch systematisches Abfragen bzw. Beschalten mit verschiedenen Spannungen (oder Strömen) und Auswertung der Effekte über den Spannungsabfall an den Widerständen RS1, RS2 bzw. RS3 der Interfaceschaltungen IF1, IF2 und IF3.

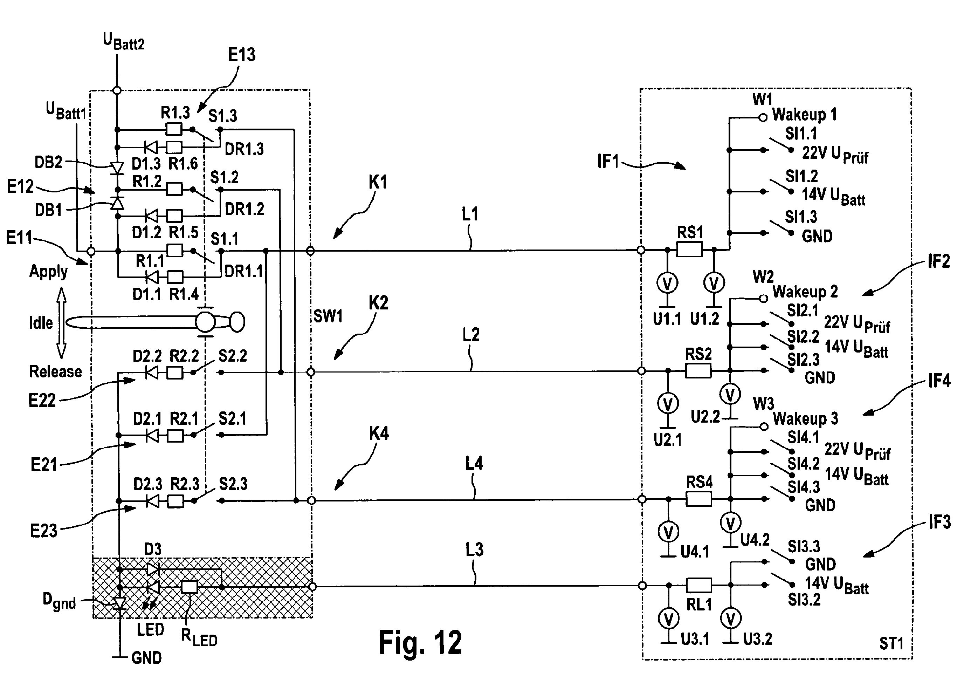

Die Schaltungsanordnung nach Figur 12 zeigt einen Bedienschalter SW1 mit dreifach redundanten Schaltebenen in den beiden Schaltstellungen "Apply" und "Release" und weist daher gegenüber der Schaltungsanordnung nach Figur 1 drei Signalleitung L1, L2 und L4 auf, die über ebenso drei Interfaceschaltungen IF1, IF2 und IF4 mit einem Steuergerät ST1 verbunden sind. Eine LED-Leitung L3 verbindet eine Interfaceschaltung IF3 mit einer Leuchtdiode LED des Bedienschalters SW1.

Im Prinzip entspricht der Aufbau dieser Schaltungsanordnung nach Figur 12 demjenigen nach Figur 1. So sind den Bedienschalter SW1 betreffend die Schaltebenen E11, E12 und E13 in der ersten Schaltstellung mit jeweils einer

Diodeneinrichtung DR1.1, DR1.2 und DR1.3 und ebenso die Schaltebenen E21, E22 und E23 der zweiten Schaltstellung wie diejenigen de Bedienschalters SW1 nach Figur 1 ausgebildet.

Für die Spannungsversorgung des Bedienschalters SW1 sind zwei Bordnetzspannungen U_{Batt1} und U_{Batt2} vorgesehen, wobei die Schaltebenen E11 und E12 mit der ersten Bordnetzspannung U_{Batt1} und die Schaltebene E13 mit der zweiten Bordnetzspannung U_{Batt2} verbunden sind. Die Dioden DB1 und DB2 dienen der gegenseitigen Abgrenzung der beiden Bordnetzspannungen U_{Batt1} und U_{Batt2}.

Die Schaltebenen E21, E22 und E23 der zweiten Schaltstellung liegen unter Zwischenschaltung einer Diode D_{gnd} auf dem Bezugspotential GND der Bordnetzspannung U_{Batt}. Auch ist ein optional zusätzlicher Anschluss der Masse GND über die Diode D3, der LED-Leitung L3 und der Interfaceschaltung IF3 möglich.

Durch die dreifach redundante Ausführung des Bedienschalters SW1 nach Figur 12 kann bei Einfachfehlern in der Spannungsversorgung, also bspw. ein Abriss der Klemme 30 oder ein Abriss der Masse GND noch sicher die Schaltstellung des Bedienschalters SW1 erkannt werden. Dies gilt auch bei Kurzschlüssen zwischen den Signalleitung L1, L2 und L4.

Die Interfaceschaltungen IF1, IF2, IF3 und IF4 entsprechen in ihrem Aufbau und ihrer Funktion denjenigen aus Figur 1.

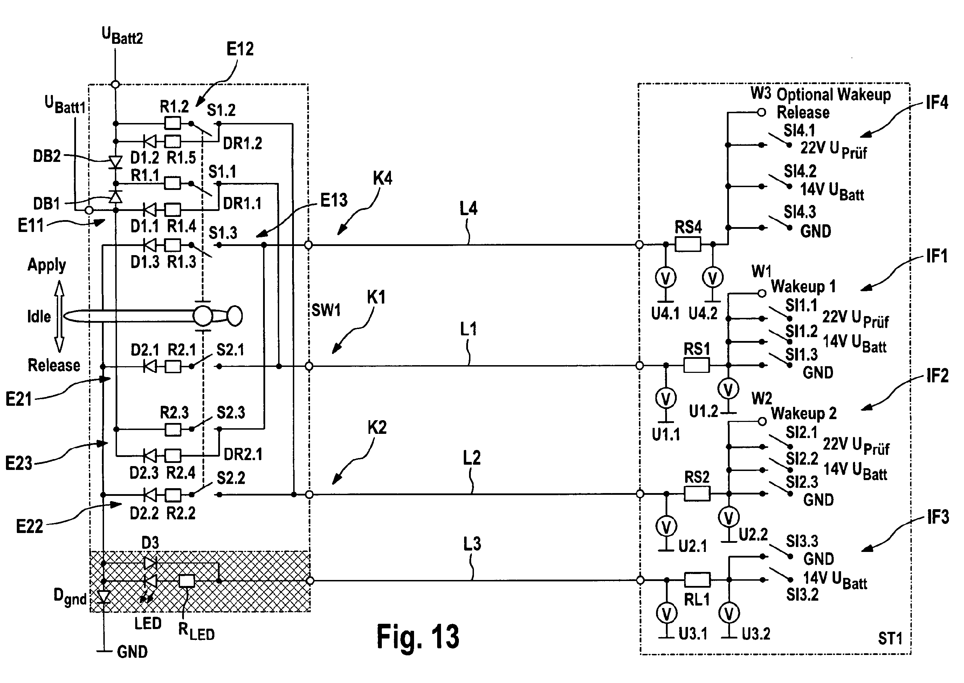

Eine zu Figur 12 alternative Ausführungsform zeigt die Schaltungsanordnung nach Figur 13, deren Bedienschalter SW1 ebenso mit dreifach redundanten Schaltebenen in beiden Schaltstellungen "Apply" und "Release" ausgebildet ist, wobei entsprechend des Bedienschalters SW1 nach Figur 2 ein "gegenläufiger" Signalpfad als dritter Kontaktzweig K3 vorgesehen ist.

So ist die erste Schaltebene E11 und die zweite Schaltebene E12 in der ersten Schaltstellung "Apply" entsprechend Figur 12 an eine erste und zweite Bordnetzspannung U_{Batt1} und U_{Batt2} angeschlossen, während die dritte Schaltebene E13 auf dem Bezugspotential GND liegt. Folglich wird die mit dieser dritten Schaltebene E13 verbundene dritte Schaltebene E23 der zweiten Schaltstellung "Release" von der ersten Bordnetzspannung U_{Batt1} versorgt.

Die Testfunktionen als auch die Wirkungsweise und Vorteile entsprechen der Schaltungsanordnung nach Figur 12.

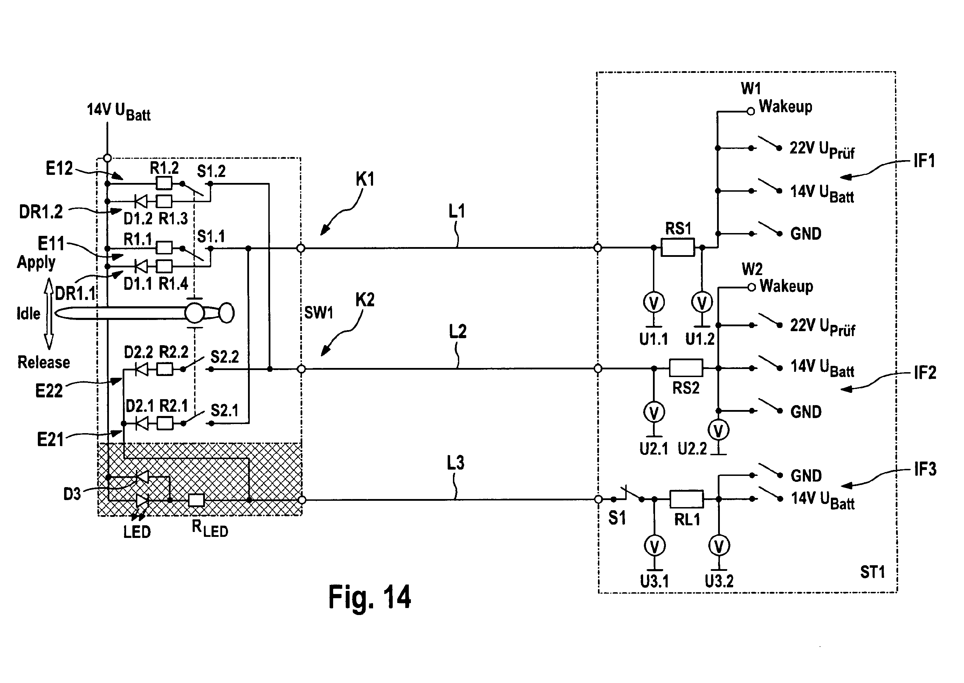

Schließlich zeigt die Schaltungsanordnung nach Figur 14 eine alternative Ausführungsform zu derjenigen nach Figur 1, bei der der Bedienschalter SW1 keinen Anschluss an Masse GND aufweist. Die Masse GND wird im Bedarfsfall über die antiparallel zur Leuchtdiode LED geschalteten Diode D3, der LED-Leitung L3 und der Interfaceschaltung IF3 zugeführt. Daher sind auch die Schaltebenen E21 und E22 der zweiten Schaltstellung des Bedienschalter SW1 mit dieser LED-Leitung L3 verbunden.

Ein Schalter S1 der Interfaceschaltung IF3 dient zur Leckstromabschaltung.

Anstelle von Spannungsquellen in den Steuergeräten können auch Stromquellen eingesetzt werden. Die Erzeugung der Prüfspannung U_{Batt} erfolgt mit allgemein bekannten Ladungspumpen, Bootstrapschaltungen oder DC/DC-Wandlern, wobei die letztgenannten auch zum Heruntersetzen auf kleinere Testspannungen eingesetzt werden.

## Patentansprüche

1. Verfahren zur Fehlererkennung eines mittels wenigstens einer Signalleitung (L1, LN1) an eine Auswerteeinheit (ST1) angeschlossenen Bedienschalters (SW1, SW2, SW3) mit wenigstens einer ersten Schaltebene (E1, E11) zur Auslösung einer Fahrzeugfunktion eines Fahrzeuges, bei dem ein die Schaltstellung spezifizierendes Signal zur Auslösung der Fahrzeugfunktion von der Auswerteeinheit (ST1) erfasst und ausgewertet wird, **dadurch gekennzeichnet, dass**
- die erste Schaltebene (E1, E11) einenends an ein erstes Potential der Bordnetzspannung (U_{Batt}) des Fahrzeugs angeschlossen wird und andernends zur Bildung eines ersten Kontaktzweiges (K1) in einer ersten Schaltstellung mit der Signalleitung (L1, LN1) verbindbar ist,
- die erste Schaltebene (E1, E11) von einer Diodeneinrichtung (DR1, DR1.1) hinsichtlich des ersten Potentials der Bordnetzspannung (U_{Batt}) in Sperrrichtung überbrückt wird,
- mittels der Auswerteeinheit (ST1) eine Prüfspannung (U_{Prüf}) erzeugt wird, deren Spannungswert betragsmäßig größer als das erste Potential ist,
- die Signalleitung (L1) des ersten Kontaktzweiges (K1) mit der Prüfspannung (U_{Prüf}) beaufschlagt wird, und
- das auf der Signalleitung (L1) des ersten Kontaktzweiges (K1) sich einstellende Potential zur Fehlererkennung durch die Auswerteeinheit (ST1) ausgewertet wird.

2. Verfahren nach Anspruch 1, **dadurch gekennzeichnet, dass**
- der Bedienschalter (SW1) in der ersten Schaltstellung mit einer zweiten parallelen Schaltebene (E12) ausgebildet ist,
- die zweite Schaltebene (E12) von einer Diodeneinrichtung (DR1.2) hinsichtlich des ersten Potentials der Bordnetzspannung (Bₐₜₜ) in Sperrrichtung überbrückt wird, und
- zur Bildung eines zweiten Kontaktzweiges (K2) die zweite Schaltebene über eine weitere Signalleitung (L2, LN2) mit der Auswerteeinheit (ST1) verbindbar ist.

3. Verfahren nach Anspruch 2, **dadurch gekennzeichnet, dass**
- der Bedienschalter (SW1) in der ersten Schaltstellung mit einer dritten parallelen Schaltebene (E13) ausgebildet wird,
- die dritte Schaltebene (E13) von einer Diodeneinrichtung (DR1.3) hinsichtlich des ersten Potentials der Bordnetzspannung (U_{Batt}) in Sperrrichtung überbrückt wird, und
- zur Bildung eines dritten Kontaktzweiges (K3) die dritte Schaltebene (E13) über eine weitere Signalleitung (L3) mit der Auswerteeinheit (ST1) verbindbar ist.

4. Verfahren nach Anspruch 2, **dadurch gekennzeichnet, dass**
- der zweite Kontaktzweig (K2) an das erste Potential der Bordnetzspannung (U_{Batt}) des Fahrzeugs angeschlossen wird,
- die Signalleitung (L2) des zweiten Kontaktzweiges (K2) mit der Prüfspannung (U_{Prüf}) beaufschlagt wird, und
- das auf der Signalleitung (L2) des zweiten Kontaktzweiges (K2) sich einstellende Potential zur Fehlererkennung durch die Auswerteeinheit (ST1) ausgewertet wird.

5. Verfahren nach Anspruch 3, **dadurch gekennzeichnet, dass**
- der dritte Kontaktzweig (K3) an das erste Potential der Bordnetzspannung (U_{Batt}) des Fahrzeugs, vorzugsweise an ein ersten Potential einer weiteren Bordnetzspannung U_{Batt2}) angeschlossen wird,
- die Signalleitung (L3) des dritten Kontaktzweiges (K3) mit der Prüfspannung (U_{Prüf}) beaufschlagt wird, und
- das auf der Signalleitung (L3) des dritten Kontaktzweiges (K3) sich einstellende Potential zur Fehlererkennung durch die Auswerteeinheit (ST1) ausgewertet wird.

6. Verfahren nach Anspruch 2, **dadurch gekennzeichnet, dass** der zweite Kontaktzweig (K2) an ein zweites Potential der Bordnetzspannung (U_{Batt}) des Fahrzeugs angeschlossen wird.

7. Verfahren nach Anspruch 3, **dadurch gekennzeichnet, dass**
- der dritte Kontaktzweig (K3) an das zweite Potential der Bordnetzspannung (U_{Batt}) des Fahrzeugs angeschlossen wird,
- die Signalleitung (L2) des zweiten Kontaktzweiges (K2) mit der Prüfspannung (U_{Prüf}) beaufschlagt wird, und
- das auf der Signalleitung (L2) des zweiten Kontaktzweiges (K2) sich einstellende Potential zur Fehlererkennung durch die Auswerteeinheit (ST1) ausgewertet wird.

8. Verfahren nach Anspruch 4, **dadurch gekennzeichnet, dass**
- der Bedienschalter (SW1) in eine zweite Schaltstellung mit einer ersten und hierzu parallelen zweiten Schaltebene (E21, E22) betätigbar ist, und
- die erste und zweite Schaltebene (E21, E22) einerseits mit einem zweiten Potential der Bordnetzspannung (U_{Batt}) verbunden wird und andererseits die erste Schaltebene (E21) mit dem ersten Kontaktzweig (K1) und die zweite Schaltebene (E22) mit dem zweiten Kontaktzweig (K2) verbunden wird.

9. Verfahren nach Anspruch 5, **dadurch gekennzeichnet, dass**
- der Bedienschalter (SW1) in eine zweite Schaltstellung mit einer ersten und hierzu parallelen zweiten und dritten Schaltebene (E21, E22, E23) betätigbar ist, und
- die erste, zweite und dritte Schaltebene (E21, E22, E23) einerseits mit dem zweiten Potential der Bordnetzspannung (U_{Batt}) verbunden wird und andererseits die erste Schaltebene (E21) mit dem ersten Kontaktzweig (K1), die zweite Schaltebene (E22) mit dem zweiten Kontaktzweig (K2)und die dritte Schaltebene (E23) mit dem dritten Kontaktzweig (K3) verbunden wird.

10. Verfahren nach Anspruch 6, **dadurch gekennzeichnet, dass**
- der Bedienschalter (SW1) in eine zweite Schaltstellung mit einer ersten und hierzu parallelen zweiten Schaltebene (E21, E22) betätigbar ist,
- die erste Schaltebene (E21) einenends mit dem ersten Potential der Bordnetzspannung (U_{Batt}) und andernends mit dem zweiten Kontaktzweig (K2) verbunden wird, und
- die zweite Schaltebene (E22 einenends mit dem zweiten Potential der Bordnetzspannung (U_{Batt}) und andernends mit dem ersten Kontaktzweig (K1) verbunden wird.

11. Verfahren nach Anspruch 7, **dadurch gekennzeichnet, dass**
- der Bedienschalter (SW1) in eine zweite Schaltstellung mit einer ersten und hierzu parallelen zweiten und dritten Schaltebene (E21, E22, E23) betätigbar ist,
- die erste Schaltebene (E21) einenends mit einem ersten Potential der Bordnetzspannung (U_{Batt1}), vorzugsweise mit einem ersten Potential einer weiteren Bordnetzspannung (U_{Batt2}) und andernends mit dem ersten Kontaktzweig (K1) verbunden wird, und
- die zweite und dritte Schaltebene (E22, E23) einenends mit dem zweiten Potential des Bordnetzes U_{Batt}) und andernends die zweite Schaltebene (E22) mit dem zweiten Kontaktzweig (K2) und die dritte Schaltebene (E23) mit dem dritten Kontaktzweig (K3) verbunden wird.

12. Verfahren nach einem der vorhergehenden Ansprüche, **dadurch gekennzeichnet, dass** das erste Potential der Bordnetzspannung (U_{Batt}) das positive Potential (14V) der Bordnetzspannung (U_{Batt}) und das zweite das Bezugspotential, die Fahrzeugmasse (GND) darstellt.

13. Verfahren nach einem der Ansprüche 1 bis 11, **dadurch gekennzeichnet, dass** das erste Potential der Bordnetzspannung (U_{Batt}) das Bezugspotential, die Fahrzeugmasse (GND) und das zweite Potential das positive Potential (14V) der Bordnetzspannung (U_{Batt}) darstellt.

14. Verfahren nach einem der vorhergehenden Ansprüche, **dadurch gekennzeichnet, dass** die Schaltebenen (E1, E11, ... E23) jeweils als Schließer gebildet werden.

15. Verfahren nach einem der vorhergehenden Ansprüche, **dadurch gekennzeichnet, dass** der Bedienschalter (SW1) mit wenigstens einer Leuchtdiode (LED) ausgebildet wird, die über eine LED-Leitung (L3) mit der Auswerteeinheit (ST1) verbunden wird.

16. Verfahren nach Anspruch 15, **dadurch gekennzeichnet, dass** dem Bedienschalter (SW1) das Bezugspotential des Bordnetzes von der Auswerteeinheit (ST1) über die LED-Leitung (L3) zugeführt wird.

17. Verfahren nach einem der vorhergehenden Ansprüche, **dadurch gekennzeichnet, dass** zur weiteren Fehlererkennung der erste und/oder zweite Kontaktzweig (K1, K2, KN1, KN2) mittels der Auswerteeinheit (ST1) mit der Bordnetzspannung (U_{Batt}) oder dem Bezugspotential (GND) der Bordnetzspannung (U_{Batt}) beaufschlagt wird und in Abhängigkeit der Schaltstellung des Bedienschalters (SW1) das sich auf den Leitungen (L1, L2, LN1, LN2) der Kontaktzweige (K1, K2, KN1, KN2) einstellende Potentiale erfasst und ausgewertet werden.

18. Verfahren nach einem der vorhergehenden Ansprüche, **dadurch gekennzeichnet, dass** die Schaltkontakte (S1.1, ... S2.3) des Bedienelementes (SW1) durch ein Strombegrenzungselement (R1, R1.1, ... R2.3), vorzugsweise einen elektrischen Widerstand, geschützt sind.

19. Bedienschalter (SW1) mit wenigstens einem eine erste Schaltebene (E1, E11) bildenden Schließerkontakt (S1, S1.1) zur Auslösung einer Fahrzeugfunktion eines Fahrzeuges, welcher mittels wenigstens einer Signalleitung (L1) an eine Auswerteeinheit (ST1) angeschlossen ist, insbesondere zur Durchführung des Verfahrens nach einem der vorhergehenden Ansprüche, **dadurch gekennzeichnet, dass**
- die erste Schaltebene (E1, E11) einenends an ein erstes Potential der Bordnetzspannung (U_{Batt}) des Fahrzeugs angeschlossen ist und andernends zur Bildung eines ersten Kontaktzweiges (K1) in einer ersten Schaltstellung mit der Signalleitung (L1, LN1) verbunden ist,
- eine Diodeneinrichtung (DR1, DR1.1) vorgesehen ist, die die erste Schaltebene hinsichtlich des ersten Potentials der Bordnetzspannung (U_{Batt}) in Sperrrichtung überbrückt,
- die Auswerteeinheit (ST1) eine Prüfspannungserzeugungseinheit (SP, IF1, IF2, IF3) zur Erzeugung einer Prüfspannung (U_{Prüf}) aufweist, deren Spannungswert betragsmäßig größer als das erste Potential ist,
- die Auswerteinheit (ST1) ausgebildet ist, die Signalleitung (L1, LN1) des ersten Kontaktzweiges (K1) mit der Prüfspannung (U_{Prüf}) zu beaufschlagen und das auf der Signalleitung (L1, LN1) des ersten Kontaktzweiges (K1) sich einstellende Potential zur Fehlererkennung auszuwerten.

20. Bedienschalter (SW1) nach Anspruch 19, **dadurch gekennzeichnet, dass**
- der Bedienschalter (SW1) in der ersten Schaltstellung mit einer zweiten parallelen Schaltebene (E12) ausgebildet ist,
- eine Diodeneinrichtung (DR1.2) vorgesehen ist, die die zweite Schaltebene (E12) hinsichtlich des ersten Potentials der Bordnetzspannung (U_{Batt}) in Sperrrichtung überbrückt, und
- zur Bildung eines zweiten Kontaktzweiges (K2, KN2) die zweite Schaltebene (E12) über eine weitere Signalleitung (L2, LN2) mit der Auswerteeinheit verbunden ist.

21. Bedienschalter (SW1) nach Anspruch 20, **dadurch gekennzeichnet, dass** der zweite Kontaktzweig (K2, KN2) an ein erstes Potential der Bordnetzspannung (U_{Batt}) des Fahrzeugs angeschlossen ist.

22. Bedienschalter (SW1) nach Anspruch 20, **dadurch gekennzeichnet, dass** der zweite Kontaktzweig (K2) an ein zweites Potential der Bordnetzspannung (U_{Batt}) des Fahrzeugs angeschlossen wird.

23. Bedienschalter (SW1) nach Anspruch 19, **dadurch gekennzeichnet, dass**
- der Bedienschalter (SW1) in der ersten Schaltstellung mit einer dritten parallelen Schaltebene (E13) ausgebildet ist,
- eine Diodeneinrichtung (DR1.3) vorgesehen ist, die die dritte Schaltebene (E1.3) hinsichtlich des ersten Potentials der Bordnetzspannung (U_{Batt}) in Sperrrichtung überbrückt, und
- zur Bildung eines dritten Kontaktzweiges (K3) die dritte Schaltebene (E13) über eine weitere Signalleitung (L3) mit der Auswerteeinheit (ST1) verbunden ist.

24. Bedienschalter (SW1) nach Anspruch 23, **dadurch gekennzeichnet, dass** der dritte Kontaktzweig (K3) an das erste Potential der Bordnetzspannung (U_{Batt1}) des Fahrzeugs, vorzugsweise an ein erstes Potential einer weiteren Bordnetzspannung (U_{Batt2}) angeschlossen wird,

25. Bedienschalter (SW1) nach Anspruch 23, **dadurch gekennzeichnet, dass** der dritte Kontaktzweig (K3) an ein zweites Potential der Bordnetzspannung (U_{Batt}) des Fahrzeugs angeschlossen wird.

26. Bedienschalter (SW1) nach Anspruch 21, **dadurch gekennzeichnet, dass**
- der Bedienschalter (SW1) in einer zweiten Schaltstellung mit einer ersten und hierzu parallelen zweiten Schaltebene (E21, E22) ausgebildet ist, und
- die erste und zweite Schaltebene (E21, E22) einerseits mit einem zweiten Potential der Bordnetzspannung (U_{Batt}) verbunden ist und andererseits die erste Schaltebene (E21) mit dem ersten Kontaktzweig (K1, KN1) und die zweite Schaltebene (E22) mit dem zweiten Kontaktzweig (K2, KN2) verbunden ist.

27. Bedienschalter (SW1) nach Anspruch 24, **dadurch gekennzeichnet, dass**
- der Bedienschalter (SW1) in einer zweiten Schaltstellung mit einer ersten und hierzu parallelen zweiten und dritten Schaltebene (E21, E22, E23) ausgebildet ist, und
- die erste, zweite und dritte Schaltebene (E21, E22, E23) einerseits mit einem zweiten Potential der Bordnetzspannung (U_{Batt}) verbunden wird und andererseits die erste Schaltebene (E21) mit dem ersten Kontaktzweig (K1), die zweite Schaltebene (E22) mit dem zweiten Kontaktzweig (K2) und die dritte Schaltebene (E23) mit dem dritten Kontaktzweig (K3) verbunden wird.

28. Bedienschalter (SW1) nach Anspruch 22, **dadurch gekennzeichnet, dass**
- der Bedienschalter (SW1) in einer zweiten Schaltstellung mit einer ersten und hierzu parallelen zweiten Schaltebene (E21, E22) ausgebildet ist,
- die erste Schaltebene (E21) einenends mit dem ersten Potential der Bordnetzspannung (U_{Batt}) und andernends mit dem ersten Kontaktzweig (K1) verbunden ist, und
- die zweite Schaltebene (E22) einenends mit einem zweiten Potential der der Bordnetzspannung (U_{Batt}) und andernends mit dem zweiten Kontaktzweig (K2) verbunden ist.

29. Bedienschalter (SW1) nach Anspruch 25, **dadurch gekennzeichnet, dass**
- der Bedienschalter (SW1) in einer zweiten Schaltstellung mit einer ersten und hierzu parallelen zweiten und dritten Schaltebene (E21, E22, E23) ausgebildet ist,
- die erste Schaltebene (E21) einenends mit dem ersten Potential der Bordnetzspannung (U_{Batt1}), vorzugsweise mit einem ersten Potential einer weiteren Bordnetzspannung (U_{Batt2}) und andernends mit dem ersten Kontaktzweig (K1) verbunden ist,
- die zweite und dritte Schaltebene (E22, E23) einenends mit einem zweiten Potential des Bordnetzes (U_{Batt}) und andernends die zweite Schaltebene (E2) mit dem zweiten Kontaktzweig (K2) und die dritte Schaltebene (E23) mit dem dritten Kontaktzweig (K3) verbunden ist.

30. Bedienschalter (SW1) nach einem der Ansprüche 19 bis 29, **dadurch gekennzeichnet, dass** das erste Potential der Bordnetzspannung (U_{Batt}) das positive Potential (14V) und das zweite Potential die Bezugsspannung, die Fahrzeugmasse (GND) darstellt.

31. Bedienschalter (SW1) nach einem der Ansprüche 19 bis 29, **dadurch gekennzeichnet, dass** das erste Potential der Bordnetzspannung (U_{Batt}) die Bezugsspannung, die Fahrzeugmasse (GND) und das zweite Potential das positive Potential (14V) der Bordnetzspannung (U_{Batt}) darstellt.

32. Verwendung eines Bedienschalters (SW1) nach einem der Ansprüche 19 bis 31 in einem Kraftfahrzeug, insbesondere um ein elektrisches Parkbremssystem zu betätigen.

## Claims

1. Method for detecting a fault of an operating switch (SW1, SW2, SW3) that is connected to an evaluating unit (ST1) by means of at least one signal line (L1, LN1) and comprises at least a first switching plane (E1, E11) for initiating a vehicle function of a vehicle, wherein a signal that specifies the switch position for initiating the vehicle function is sensed by the evaluating unit (ST1) and evaluated, **characterized in that**:
- the first switching plane (E1, E11) is connected at one end to a first potential of the vehicle electrical system voltage (U_{Batt}) of the vehicle and it can be connected at the other end to the signal line (L1, LN1) in order to form a first contact branch (K1) in a first switch position,
- the first switching plane (E1, E11) is bridged by a diode device (DR1, DR1.1) in the non-conducting direction with respect to the first potential of the vehicle electrical system voltage (U_{Batt}),
- the evaluating unit (ST1) generates a test voltage (U_{Test}), the magnitude of which is greater than the first potential,
- the test voltage (U_{Test}) is applied to the signal line (L1) of the first contact branch (K1), and
- the potential that is being applied to the signal line (L1) of the first contact branch (K1) is evaluated by means of the evaluating unit (ST1) in order to detect a fault.

2. Method according to Claim 1, **characterized in that**:
- the operating switch (SW1) in the first switch position is embodied with a second parallel switching plane (E12),
- the second switching plane (E12) is bridged by a diode device (DR1.2) in the non-conducting direction with respect to the first potential of the vehicle electrical system voltage (Bₐₜₜ), and
- in order to form a second contact branch (K2) the second switching plane can be connected by way of a further signal line (L2, LN2) to the evaluating unit (ST1).

3. Method according to Claim 2, **characterized in that**:
- the operating switch (SW1) in the first switch position is embodied with a third parallel switching plane (E13),
- the third switching plane (E13) is bridged by a diode device (DR1.3) in the non-conducting direction with respect to the first potential of the vehicle electrical system voltage (Bₐₜₜ), and
- in order to form a third contact branch (K3) the third switching plane (E13) can be connected by way of a further signal line (L3) to the evaluating unit (ST1).

4. Method according to Claim 2, **characterized in that**:
- the second contact branch (K2) is connected to the first potential of the vehicle electrical system voltage (U_{Batt}) of the vehicle,
- the test voltage (U_{Test}) is applied to the signal line (L2) of the second contact branch (K2), and,
- the potential that is being applied to the signal line (L2) of the second contact branch (K2) is evaluated by means of the evaluating unit (ST1) in order to detect a fault.

5. Method according to Claim 3, **characterized in that**:
- the third contact branch (K3) is connected to the first potential of the vehicle electrical system voltage (U_{Batt}) of the vehicle, preferably to a first potential of a further vehicle electrical system (U_{Batt2}),
- the test voltage (U_{Test}) is applied to the signal line (L3) of the third contact branch (K3), and,
- the potential that is being applied to the signal line (L3) of the third contact branch (K3) is evaluated by means of the evaluating unit (ST1) in order to detect a fault.

6. Method according to Claim 2, **characterized in that** the second contact branch (K2) is connected to a second potential of the vehicle electrical system voltage (U_{Batt}) of the vehicle.

7. Method according to Claim 3, **characterized in that**:
- the third contact branch (K3) is connected to the second potential of the vehicle electrical system voltage (U_{Batt}) of the vehicle,
- the test voltage (U_{Test}) is applied to the signal line (L2) of the second contact branch (K2), and,
- the potential that is being applied to the signal line (L2) of the first contact branch (K2) is evaluated by means of the evaluating unit (ST1) in order to detect a fault.

8. Method according to Claim 4, **characterized in that**:
- the operating switch (SW1) can be actuated into a second switch position having a first and thereto parallel second switching plane (E21, E22), and
- the first and second switching plane (E21, E22) are connected on the one hand to a second potential of the vehicle electrical system voltage (U_{Batt}) and on the other hand the first switching plane (E21) is connected to the first contact branch (K1) and the second switching plane (E22) is connected to the second contact branch (K2).

9. Method according to Claim 5, **characterized in that**:
- the operating switch (SW1) can be actuated into a second switch position having a first and thereto parallel second and third switching plane (E21, E22, E23), and
- the first, second and third switching plane (E21, E22, E23) are connected on the one hand to the second potential of the vehicle electrical system voltage (U_{Batt}) and on the other hand the first switching plane (E21) is connected to the first contact branch (K1), the second switching plane (E22) is connected to the second contact branch (K2) and the third switching plane (E23) is connected to the third contact branch (K3).

10. Method according to Claim 6, **characterized in that**:
- the operating switch (SW1) can be actuated into a second switch position having a first and thereto parallel second switching plane (E21, E22),
- the first switching plane (E21) is connected at one end to the first potential of the vehicle electrical system voltage (U_{Batt}) and at the other end to the second contact branch (K2), and
- the second switching plane (E22) is connected at one end to the second potential of the vehicle electrical system voltage (U_{Batt}) and at the other end to the first contract branch (K1).

11. Method according to Claim 7, **characterized in that**:
- the operating switch (SW1) can be actuated into a second switch position having a first and thereto parallel second and third switching plane (E21, E22, E23),
- the first switching plane (E21) is connected at one end to a first potential of the vehicle electrical system voltage (U_{Batt1}), preferably to a first potential of a further vehicle electrical system voltage (U_{Batt2}) and at the other end to the first contact branch (K1), and
- the second and third switching plane (E22, E23) at one end to the second potential of the vehicle electrical system (U_{Batt}) and at the other end the second switching plane (E22) is connected to the second contact branch (K2) and the third switching plane (E23) is connected to the third contact branch (K3).

12. Method according to any one of the preceding claims, **characterized in that** the first potential of the vehicle electrical system voltage (U_{Batt}) represents the positive potential (14V) of the vehicle electrical system voltage (U_{Batt}) and the second represents the reference potential, the vehicle ground (GND).

13. Method according to any one of Claims 1 to 11, **characterized in that** the first potential of the vehicle electrical system voltage (U_{Batt}) represents the reference potential, the vehicle ground (GND) and the second potential represents the positive potential (14V) of the vehicle electrical system voltage (U_{Batt}).

14. Method according to any one of the preceding claims, **characterized in that** the switching planes (E1, E11,... E23) are embodied in each case as a contact element.

15. Method according to any one of the preceding claims, **characterized in that** the operating switch (SW1) is embodied with at least one light-emitting diode (LED) that is connected by way of an LED line (L3) to the evaluating unit (ST1) .

16. Method according to Claim 15, **characterized in that** the reference potential of the vehicle electrical system is supplied from the evaluating unit (ST1) to the operating switch (SW1) by way of the LED line (L3).

17. Method according to any one of the preceding claims, **characterized in that** in order to continue to detect faults the vehicle electrical system voltage (U_{Batt}) or the reference voltage (GND) of the vehicle electrical system voltage (U_{Batt}) is applied to the first and/or second contact branch (K1, K2, KN1, KN2) by means of the evaluating unit (ST1) and in dependence upon the switch position of the operating switch (SW1) the potentials that are being applied on the lines (L1, L2, LN1, LN2) of the contact branches (K1, K2, KN1, KN2) are sensed and evaluated.

18. Method according to any one of the preceding claims, **characterized in that** the switching contacts (S1.1, ... S2.3) of the operating element (SW1) are protected by means of a current limiting element (R1, R1.1, ... R2.3), preferably an electric resistor.

19. Operating switch (SW1) comprising at least one make-contact element (S1, S1.1) that forms a first switching plane (E1, E11) for initiating a vehicle function of a vehicle, which operating switch is connected to an evaluating unit (ST1) by means of at least one signal line (L1), in particular for performing the method according to any one of the preceding claims, **characterized in that**:
- the first switching plane (E1, E11) is connected at one end to a first potential of the vehicle electrical system voltage (U_{Batt}) of the vehicle and is connected at the other end to the signal line (L1, LN1) in order to form a first contact branch (K1) in a first switch position,
- a diode device (DR1, DR1.1) is provided that bridges the first switching plane in the nonconducting direction with respect to the first potential of the vehicle electrical system voltage (U_{Batt}),
- the evaluating unit (ST1) comprises a test voltage generating unit (SP, IF1, IF2, IF3) for generating a test voltage (U_{Test}), the magnitude of which is greater than the first potential,
- the evaluating unit (ST1) is embodied to apply the test voltage (U_{Test}) to the signal line (L1, LN1) of the first contact branch (K1) and to evaluate the potential that is being applied to the signal line (L1, LN1) of the first contact branch (K1) in order to detect a fault.

20. Operating switch (SW1) according to Claim 19, **characterized in that**:
- the operating switch (SW1) in the first switch position is embodied with a second parallel switching plane (E12),
- a diode device (DR1.2) is provided that bridges the second switching plane (E12) in the nonconducting direction with respect to the first potential of the vehicle electrical system voltage (U_{Batt}), and
- in order to form a second contact branch (K2, KN2) the second switching plane (E12) can be connected by way of a further signal line (L2, LN2) to the evaluating unit.

21. Operating switch (SW1) according to Claim 20, **characterized in that** the second contact branch (K2, KN2) is connected to a first potential of the vehicle electrical system voltage (U_{Batt}) of the vehicle.

22. Operating switch (SW1) according to Claim 20, **characterized in that** the second contact branch (K2) is connected to a second potential of the vehicle electrical system voltage (U_{Batt}) of the vehicle.

23. Operating switch (SW1) according to Claim 19, **characterized in that**:
- the operating switch (SW1) in the first switch position is embodied with a third parallel switching plane (E13),
- a diode device (DR1.3) is provided that bridges the third switching plane (E1.3) in the nonconducting direction with respect to the first potential of the vehicle electrical system voltage (U_{Batt}), and
- in order to form a third contact branch (K3) the third switching plane (E13) is connected by way of a further signal line (L3) to the evaluating unit (ST1).

24. Operating switch (SW1) according to Claim 23, **characterized in that** the third contact branch (K3) is connected to the first potential of the vehicle electrical system voltage (U_{Batt1}) of the vehicle, preferably to a first potential of a further vehicle electrical system voltage (U_{Batt2}).

25. Operating switch (SW1) according to Claim 23, **characterized in that** the third contact branch (K3) is connected to a second potential of the vehicle electrical system voltage (U_{Batt}) of the vehicle.

26. Operating switch (SW1) according to Claim 21, **characterized in that**:
- the operating switch (SW1) in a second switch position is embodied with a first and thereto parallel second switching plane (E21, E22), and
- the first and second switching plane (E21, E22) are connected on the one hand to a second potential of the vehicle electrical system voltage (U_{Batt}) and on the other hand the first switching plane (E21) is connected to the first contact branch (K1, KN1) and the second switching plane (E22) is connected to the second contact branch (K2, KN2).

27. Operating switch (SW1) according to Claim 24, **characterized in that**:
- the operating switch (SW1) in a second switch position is embodied with a first and thereto parallel second and third switching plane (E21, E22, E23), and
- the first, second and third switching plane (E21, E22, E23) are connected on the one hand to a second potential of the vehicle electrical system voltage (U_{Batt}) and on the other hand the first switching plane (E21) is connected to the first contact branch (K1), the second switching plane (E22) is connected to the second contact branch (K2) and the third switching plane (E23) is connected to the third contact branch (K3).

28. Operating switch (SW1) according to Claim 22, **characterized in that**:
- the operating switch (SW1) in a second switch position is embodied with a first and thereto parallel second switching plane (E21, E22),
- the first switching plane (E21) is connected at one end to the first potential of the vehicle electrical system voltage (U_{Batt}) and at the other end to the first contact branch (K1), and
- the second switching plane (E22) is connected at one end to a second potential of the vehicle electrical system voltage (U_{Batt}) and at the other end to the second contact branch (K2).

29. Operating switch (SW1) according to Claim 25, **characterized in that**:
- the operating switch (SW1) in a second switch position is embodied with a first and thereto parallel second and third switching plane (E21, E22, E23),
- the first switching plane (E21) is connected at one end to the first potential of the vehicle electrical system voltage (U_{Batt1}), preferably to a first potential of a further vehicle electrical system voltage (U_{Batt2}) and at the other end to the first contact branch (K1),
- the second and third switching plane (E22, E23) at one end to a second potential of the vehicle electrical system (U_{Batt}) and at the other end the second switching plane (E2) is connected to the second contact branch (K2) and the third switching plane (E23) is connected to the third contact branch (K3).

30. Operating switch (SW1) according to any one of Claims 19 to 29, **characterized in that** the first potential of the vehicle electrical system voltage (U_{Batt}) represents the positive potential (14V), and the second potential represents the reference voltage, the vehicle ground (GND).

31. Operating switch (SW1) according to any one of Claims 19 to 29, **characterized in that** the first potential of the vehicle electrical system voltage (U_{Batt}) represents the reference voltage, the vehicle ground (GND), and the second potential represents the positive potential (14V) of the vehicle electrical system voltage (U_{Batt}).

32. Use of an operating switch (SW1) according to any one of Claims 19 to 31 in a motor vehicle, in particular in order to actuate an electric parking brake system.

## Revendications

1. Procédé permettant d'identifier une défaillance d'un commutateur de commande (SW1, SW2, SW3) raccordé au moyen d'au moins une ligne de signal (L1, LN1) à une unité d'évaluation (ST1) comportant au moins un premier niveau de commutation (E1, E11) pour déclencher une fonction de véhicule d'un véhicule, dans lequel un signal spécifiant la position de commutation pour déclencher la fonction de véhicule est détecté et évalué par l'unité d'évaluation (ST1), **caractérisé en ce que**
- le premier niveau de commutation (E1, E11), à une extrémité, est raccordé à un premier potentiel de la tension du réseau de bord (U_{Batt}) du véhicule et, à l'autre extrémité, peut être connecté, à une première position de commutation, à la ligne de signal (L1, LN1) pour former une première branche de contact (K1),
- le premier niveau de commutation (E1, E11) est court-circuité par un dispositif à diode (DR1, DR1.1) en ce qui concerne le premier potentiel de la tension du réseau de bord (U_{Batt}) dans la direction non passante,
- une tension de test (Up_{rüf}) dont la valeur de tension est supérieure au premier potentiel est générée au moyen de l'unité d'évaluation (ST1),
- la tension de test (U_{prüf}) est appliquée à la ligne de signal (L1) de la première branche de contact (K1), et
- le potentiel apparaissant sur la ligne de signal (L1) de la première branche de contact (K1) est évalué par l'unité d'évaluation (ST1) pour identifier les défaillances.

2. Procédé selon la revendication 1, **caractérisé en ce que**
- le commutateur de commande (SW1), à la première position de commutation, est réalisé de manière à comporter un deuxième niveau de commutation parallèle (E12),
- le deuxième niveau de commutation (E12) est court-circuité dans la direction non passante par un dispositif à diode (DR1.2) en ce qui concerne le premier potentiel de la tension du réseau de bord (U_{Batt}), et
- le deuxième niveau de commutation peut être connecté par l'intermédiaire d'une autre ligne de signal (L2, LN2) à l'unité d'évaluation (ST1) pour former une deuxième branche de contact (K2).

3. Procédé selon la revendication 2, **caractérisé en ce que**
- le commutateur de commande (SW1), à la première position de commutation, est réalisé de manière à comporter un troisième niveau de commutation parallèle (E13),
- le troisième niveau de commutation (E13) est court-circuité dans la direction non passante par un dispositif à diode (DR1.3) en ce qui concerne le premier potentiel de la tension du réseau de bord (U_{Batt}), et
- le troisième niveau de commutation (E13) peut être connecté par l'intermédiaire d'une autre ligne de signal (L3) à l'unité d'évaluation (ST1) pour former une troisième branche de contact (K3).

4. Procédé selon la revendication 2, **caractérisé en ce que**
- la deuxième branche de contact (K2) est raccordée au premier potentiel de la tension du réseau de bord (U_{Batt}) du véhicule,
- la tension de test (U_{prüf}) est appliquée à la ligne de signal (L2) de la deuxième branche de contact (K2), et
- le potentiel apparaissant sur la ligne de signal (L2) de la deuxième branche de contact (K2) est évalué par l'unité d'évaluation (ST1) pour identifier les défaillances.

5. Procédé selon la revendication 3, **caractérisé en ce que**
- la troisième branche de contact (K3) est raccordée au premier potentiel de la tension du réseau de bord (U_{Batt}) du véhicule, de préférence à un premier potentiel d'une autre tension de bord (U_{Batt}),
- la tension de test (U_{prüf}) est appliquée à la ligne de signal (L3) de la troisième branche de contact (K3), et
- le potentiel apparaissant sur la ligne de signal (L3) de la troisième branche de contact (K3) est évalué par l'unité d'évaluation (ST1) pour identifier les défaillances.

6. Procédé selon la revendication 2, **caractérisé en ce que** la deuxième branche de contact (K2) est raccordée à un deuxième potentiel de la tension du réseau de bord (U_{Batt}) du véhicule.

7. Procédé selon la revendication 3, **caractérisé en ce que**
- la troisième branche de contact (K3) est raccordée au deuxième potentiel de la tension du réseau de bord (U_{Batt}) du véhicule,
- la tension de test (U_{prüf}) est appliquée à la ligne de signal (L2) de la deuxième branche de contact (K2), et
- le potentiel apparaissant sur la ligne de signal (L2) de la deuxième branche de contact (K2) est évalué par l'unité d'évaluation (ST1) pour identifier les défaillances.

8. Procédé selon la revendication 4, **caractérisé en ce que**
- le commutateur de commande (SW1), à une deuxième position de commutation, peut être actionné au moyen d'un premier niveau de commutation et d'un deuxième niveau de commutation parallèle à celui-ci (E21, E22), et
- les premier et deuxième niveaux de commutation (E21, E22) sont d'une part connectés à un deuxième potentiel de la tension du réseau de bord (U_{Batt}) et d'autre part, le premier niveau de commutation (E21) est connecté à la première branche de contact (K1) et le deuxième niveau de commutation (E22) est connecté à la deuxième branche de contact (K2).

9. Procédé selon la revendication 5, **caractérisé en ce que**
- le commutateur de commande (SW1), à une deuxième position de commutation, peut être actionné au moyen d'un premier niveau de commutation et de deuxième et troisième niveaux de commutation (E21, E22, E23) parallèles à celui-ci, et
- les premier, deuxième et troisième niveaux de commutation (E21, E22, E23) sont d'une part connectés au deuxième potentiel de la tension du réseau de bord (U_{Batt}) et d'autre part, le premier niveau de commutation (E21) est connecté à la première branche de contact (K1), le deuxième niveau de commutation (E22) est connecté à la deuxième branche de contact (K2) et le troisième niveau de commutation (E23) est connecté à la troisième branche de contact (K3).

10. Procédé selon la revendication 6, **caractérisé en ce que**
- le commutateur de commande (SW1), à une deuxième position de commutation, peut être actionné au moyen d'un premier niveau de commutation et d'un deuxième niveau de commutation parallèle à celui-ci (E21, E22),
- le premier niveau de commutation (E21), à une extrémité, est connecté au premier potentiel de la tension du réseau de bord (U_{Batt}) et, à l'autre extrémité, est connecté à la deuxième branche de contact (K2), et
- le deuxième niveau de commutation (E22), à une extrémité, est connecté au deuxième potentiel de la tension du réseau de bord (U_{Batt}) et, à l'autre extrémité, est connecté à la première branche de contact (K1).

11. Procédé selon la revendication 7, **caractérisé en ce que**
- le commutateur de commande (SW1), à une deuxième position de commutation, peut être actionné au moyen d'un premier niveau de commutation et de deuxième et troisième niveaux de commutation (E21, E22, E23) parallèles à celui-ci,
- le premier niveau de commutation (E21), à une extrémité, est connecté à un premier potentiel de la tension du réseau de bord (U_{Batt1}), de préférence à un premier potentiel d'une autre tension de bord (U_{Batt2}) et, à l'autre extrémité, est connecté à la première branche de contact (K1), et
- les deuxième et troisième niveaux de commutation (E22, E23), à une extrémité, sont connectés au deuxième potentiel du réseau de bord (U_{Batt}) et, à l'autre extrémité, le deuxième niveau de commutation (E22) est connecté à la deuxième branche de contact (K2) et le troisième niveau de commutation (E23) est connecté à la troisième branche de contact (K3).

12. Procédé selon l'une quelconque des revendications précédentes, **caractérisé en ce que** le premier potentiel de la tension du réseau de bord (U_{Batt}) représente le potentiel positif (14V) de la tension du réseau de bord (U_{Batt}) et **en ce que** le deuxième représente le potentiel de référence, c'est-à-dire la masse du véhicule (GND).

13. Procédé selon l'une quelconque des revendications 1 à 11, **caractérisé en ce que** le premier potentiel de la tension du réseau de bord (U_{Batt}) représente le potentiel de référence, c'est-à-dire la masse du véhicule (GND), et **en ce que** le deuxième potentiel représente le potentiel positif (14V) de la tension du réseau de bord (U_{Batt}).

14. Procédé selon l'une quelconque des revendications précédentes, **caractérisé en ce que** les niveaux de commutation (E1, E11, ... E23) sont respectivement réalisés sous la forme de contacts à fermeture.

15. Procédé selon l'une quelconque des revendications précédentes, **caractérisé en ce que** le commutateur de commande (SW1) est réalisé de manière à comporter au moins une diode électroluminescente (LED) qui est connectée à l'unité d'évaluation (ST1) par l'intermédiaire d'une ligne de LED (L3).

16. Procédé selon la revendication 15, **caractérisé en ce que** le potentiel de référence du réseau de bord est délivré par l'unité d'évaluation (ST1) au commutateur de commande (SW1) par l'intermédiaire de la ligne de LED (L3).

17. Procédé selon l'une quelconque des revendications précédentes, **caractérisé en ce que**, pour une identification supplémentaire de défaillances, la tension du réseau de bord (U_{Batt}) ou le potentiel de référence (GND) de la tension du réseau de bord (U_{Batt}) est appliqué à la première et/ou à la deuxième branche de contact (K1, K2, KN1, KN2) au moyen de l'unité d'évaluation (ST1) et **en ce que** les potentiels apparaissant sur les lignes (L1, L2, LN1, LN2) des branches de contact (K1, K2, KN1, KN2) sont détectés et évalués en fonction de la position de commutation du commutateur de commande (SW1).

18. Procédé selon l'une quelconque des revendications précédentes, **caractérisé en ce que** les contacts de commutation (S1.1, ... S2.3) de l'élément de commande (SW1) sont protégés par un élément de limitation de courant (R1, R1.1, ... R2.3), de préférence une résistance électrique.

19. Commutateur de commande (SW1) comportant au moins un contact de fermeture (S1, S1.1) formant un premier niveau de commutation (E1, E11) qui est raccordé au moyen d'au moins une ligne de signal (L1) à une unité d'évaluation (ST1) pour déclencher une fonction de véhicule d'un véhicule, notamment pour mettre en oeuvre le procédé selon l'une quelconque des revendications précédentes, **caractérisé en ce que**
- le premier niveau de commutation (E1, E11), à une extrémité, est raccordé à un premier potentiel de la tension du réseau de bord (U_{Batt}) du véhicule et, à l'autre extrémité, est connecté, à une première position de commutation, à la ligne de signal (L1, LN1) pour former une première branche de contact (K1),
- il est prévu un dispositif à diode (DR1, DR1.1) qui court-circuite le premier niveau de commutation en ce qui concerne le premier potentiel de la tension du réseau de bord (U_{Batt}) dans la direction non passante,
- l'unité d'évaluation (ST1) comporte une unité génératrice de tension de test (SP, IF1, IF2, IF3) destinée à générer une tension de test (U_{prüf}) dont la valeur de tension est supérieure au premier potentiel,
- l'unité d'évaluation (ST1) est réalisée de manière à appliquer la tension de test (U_{pruf}) à la ligne de signal (L1, LN1) de la première branche de contact (K1) et de manière à évaluer le potentiel apparaissant sur la ligne de signal (L1, LN1) de la première branche de contact (K1) pour identifier les défaillances.

20. Commutateur de commande (SW1) selon la revendication 19, **caractérisé en ce que**
- le commutateur de commande (SW1), à la première position de commutation, est réalisé de manière à comporter un deuxième niveau de commutation parallèle (E12),
- il est prévu un dispositif à diode (DR1.2) qui court-circuite le deuxième niveau de commutation (E12) en ce qui concerne le premier potentiel de la tension du réseau de bord (U_{Batt}) dans la direction non passante, et
- le deuxième niveau de commutation (E12) est connecté par l'intermédiaire d'une autre ligne de signal (L2, LN2) à l'unité d'évaluation pour former une deuxième branche de contact (K2, KN2).

21. Commutateur de commande (SW1) selon la revendication 20, **caractérisé en ce que** la deuxième branche de contact (K2, KN2) est raccordée à un premier potentiel de la tension du réseau de bord (U_{Batt}) du véhicule.

22. Commutateur de commande (SW1) selon la revendication 20, **caractérisé en ce que** la deuxième branche de contact (K2) est raccordée à un deuxième potentiel de la tension du réseau de bord (U_{Batt}) du véhicule.

23. Commutateur de commande (SW1) selon la revendication 19, **caractérisé en ce que**
- le commutateur de commande (SW1), à la première position de commutation, est réalisé de manière à comporter un troisième niveau de commutation parallèle (E13),
- il est prévu un dispositif à diode (DR1.3) qui court-circuite le troisième niveau de commutation (E1.3) en ce qui concerne le premier potentiel de la tension du réseau de bord (U_{Batt}) dans la direction non passante, et
- le troisième niveau de commutation (E13) est connecté par l'intermédiaire d'une autre ligne de signal (L3) à l'unité d'évaluation (ST1) pour former une troisième branche de contact (K3).

24. Commutateur de commande (SW1) selon la revendication 23, **caractérisé en ce que** la troisième branche de contact (K3) est raccordée au premier potentiel de la tension du réseau de bord (U_{Batt1}) du véhicule, de préférence à un premier potentiel d'une autre tension de bord (U_{Batt2}).

25. Commutateur de commande (SW1) selon la revendication 23, **caractérisé en ce que** la troisième branche de contact (K3) est raccordée à un deuxième potentiel de la tension du réseau de bord (U_{Batt}) du véhicule.

26. Commutateur de commande (SW1) selon la revendication 21, **caractérisé en ce que**
- le commutateur de commande (SW1), à une deuxième position de commutation, est réalisé de manière à comporter un premier niveau de commutation et un deuxième niveau de commutation parallèle à celui-ci (E21, E22), et
- les premier et deuxième niveaux de commutation (E21, E22) sont d'une part connectés à un deuxième potentiel de la tension du réseau de bord (U_{Batt}) et d'autre part, le premier niveau de commutation (E21) est connecté à la première branche de contact (K1, KN1) et le deuxième niveau de commutation (E22) est connecté à la deuxième branche de contact (K2, KN2).

27. Commutateur de commande (SW1) selon la revendication 24, **caractérisé en ce que**
- le commutateur de commande (SW1), à une deuxième position de commutation, est réalisé de manière à comporter un premier niveau de commutation et des deuxième et troisième niveaux de commutation parallèles à celui-ci (E21, E22, E23), et
- les premier, deuxième et troisième niveaux de commutation (E21, E22, E23) sont d'une part connectés à un deuxième potentiel de la tension du réseau de bord (U_{Batt}) et d'autre part, le premier niveau de commutation (E21) est connecté à la première branche de contact (K1), le deuxième niveau de commutation (E22) est connecté à la deuxième branche de contact (K2) et le troisième niveau de commutation (E23) est connecté à la troisième branche de contact (K3).

28. Commutateur de commande (SW1) selon la revendication 22, **caractérisé en ce que**
- le commutateur de commande (SW1), à une deuxième position de commutation, est réalisé de manière à comporter un premier niveau de commutation et un deuxième niveau de commutation parallèle à celui-ci (E21, E22),
- le premier niveau de commutation (E21), à une extrémité, est connecté au premier potentiel de la tension du réseau de bord (U_{Batt}) et, à l'autre extrémité, est connecté à la première branche de contact (K1), et
- le deuxième niveau de commutation (E22), à une extrémité, est connecté à un deuxième potentiel de la tension du réseau de bord (U_{Batt}) et, à l'autre extrémité, est connecté à la deuxième branche de contact (K2).

29. Commutateur de commande (SW1) selon la revendication 25, **caractérisé en ce que**
- le commutateur de commande (SW1), à une deuxième position de commutation, est réalisé de manière à comporter un premier niveau de commutation et des deuxième et troisième niveaux de commutation parallèles à celui-ci (E21, E22, E23),
- le premier niveau de commutation (E21), à une extrémité, est connecté au premier potentiel de la tension du réseau de bord (U_{Batt1}), de préférence à un premier potentiel d'une autre tension de bord (U_{Batt2}) et, à l'autre extrémité, est connecté à la première branche de contact (K1),
- les deuxième et troisième niveaux de commutation (E22, E23), à une extrémité, sont connectés à un deuxième potentiel du réseau de bord (U_{Batt}) et, à l'autre extrémité, le deuxième niveau de commutation (E2) est connecté à la deuxième branche de contact (K2) et le troisième niveau de commutation (E23) est connecté à la troisième branche de contact (K3).

30. Commutateur de commande (SW1) selon l'une quelconque des revendications 19 à 29, **caractérisé en ce que** le premier potentiel de la tension du réseau de bord (U_{Batt}) représente le potentiel positif (14V) et **en ce que** le deuxième potentiel représente la tension de référence, c'est-à-dire la masse du véhicule (GND).

31. Commutateur de commande (SW1) selon l'une quelconque des revendications 19 à 29, **caractérisé en ce que** le premier potentiel de la tension du réseau de bord (U_{Batt}) représente la tension de référence, c'est-à-dire la masse du véhicule (GND), et **en ce que** le deuxième potentiel représente le potentiel positif (14V) de la tension du réseau de bord (U_{Batt}).

32. Utilisation d'un commutateur de commande (SW1) selon l'une quelconque des revendications 19 à 31 dans un véhicule automobile, notamment pour actionner un système de frein de stationnement électrique.
